(19) **Europäisches Patentamt**
**European Patent Office**
**Office européen des brevets**

(11) **EP 4 336 862 A1**

(12) **EUROPEAN PATENT APPLICATION**
published in accordance with Art. 153(4) EPC

(43) Date of publication:
**13.03.2024 Bulletin 2024/11**

(21) Application number: **22798806.0**

(22) Date of filing: **01.02.2022**

(51) International Patent Classification (IPC):
***H04S 7/00*** *(2006.01)*

(52) Cooperative Patent Classification (CPC):
**H04S 7/00**

(86) International application number:
**PCT/JP2022/003737**

(87) International publication number:
**WO 2022/234698 (10.11.2022 Gazette 2022/45)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **07.05.2021 JP 2021079174**

(71) Applicant: **Sony Group Corporation
Tokyo 108-0075 (JP)**

(72) Inventors:
• **HATANAKA Mitsuyuki
Tokyo 108-0075 (JP)**
• **TSUJI Minoru
Tokyo 108-0075 (JP)**

(74) Representative: **2SPL Patentanwälte PartG mbB
Landaubogen 3
81373 München (DE)**

(54) **INFORMATION PROCESSING DEVICE AND METHOD, AND PROGRAM**

(57)      The present technology relates to an information processing device, an information processing method, and a program capable of realizing content reproduction based on an intention of a content creator. The information processing device includes a listener position information acquisition unit that acquires listener position information; a viewpoint selection unit that selects a plurality of reference viewpoints forming a region including a listening position at a predetermined time; a reference viewpoint information acquisition unit that acquires viewpoint position information of the plurality of reference viewpoints, and object position information of an object of the plurality of reference viewpoints; and an object position calculation unit that, in a case where, at a time different from the predetermined time, a listening position is out of the region including the listening position at the predetermined time, calculates position information of the object of the listening position on the basis of the object position information of the plurality of reference viewpoints forming the region including the listening position at the different time, or outputs the position information obtained last. The present technology can be applied to the information processing device.

FIG. 14

**Description**

TECHNICAL FIELD

The present technology relates to information processing device and method, and a program, and particularly relates to information processing device and method, and a program which can realize content reproduction based on an intention of a content creator.

BACKGROUND ART

For example, in a free viewpoint space, each object arranged in the space using an absolute coordinate system is arranged in a fixed manner (for example, refer to Patent Document 1).

In this case, the orientation of each object viewed from an arbitrary listening position is uniquely obtained on the basis of a coordinate position of a listener in the absolute space, the face orientation, and a relationship to the object, the gain of each object is uniquely obtained on the basis of a distance from the listening position, and the sound of each object is reproduced.

CITATION LIST

PATENT DOCUMENT

PATENT DOCUMENT 1: WO 2019/198540

SUMMARY OF THE INVENTION

PROBLEMS TO BE SOLVED BY THE INVENTION

On the other hand, there are points to be emphasized for the artistry as content and the listener.

For example, there is a case where it is desirable that an object is in front of a music content, such as a musical instrument or a player at a certain listening point where the content is desired to be emphasized, or a player who is desired to be emphasized in sports content.

In view of such a circumstance, there is a possibility that the mere physical relationship between the listener and the object as described above does not sufficiently convey the amusement of the content.

The present technology has been made in view of such a situation, and an object thereof is to realize content reproduction based on an intention of a content creator while following a free position of a listener.

SOLUTIONS TO PROBLEMS

An information processing device according to an aspect of the present technology includes a listener position information acquisition unit that acquires listener position information indicating a listening position; a viewpoint selection unit that selects, from among a plurality of reference viewpoints, a plurality of the reference viewpoints forming a region including the listening position at a predetermined time; a reference viewpoint information acquisition unit that acquires viewpoint position information of the plurality of the reference viewpoints, and object position information of an object of the reference viewpoint for each of the plurality of the reference viewpoints; and an object position calculation unit that, in a case where, at a time different from the predetermined time, the listening position is out of the region including the listening position at the predetermined time, calculates position information of the object of the listening position on the basis of the object position information of the plurality of the reference viewpoints forming the region including the listening position at the different time, or outputs the position information of the object of the listening position obtained last.

An information processing method or a program according to another aspect of the present technology includes acquiring listener position information indicating a listening position; selecting, from among a plurality of reference viewpoints, a plurality of the reference viewpoints forming a region including the listening position at a predetermined time; acquiring viewpoint position information of the plurality of the reference viewpoints, and object position information of an object of the reference viewpoint for each of the plurality of the reference viewpoints; and in a case where, at a time different from the predetermined time, the listening position is out of the region including the listening position at the predetermined time, calculating position information of the object of the listening position on the basis of the object position information of the plurality of the reference viewpoints forming the region including the listening position at the different time, or outputting the position information of the object of the listening position obtained last.

In the aspect of the present technology, the listener position information indicating the listening position is acquired; from among a plurality of reference viewpoints, a plurality of the reference viewpoints forming a region including the listening position at a predetermined time is selected; the viewpoint position information of the plurality of the reference viewpoints, and object position information of an object of the reference viewpoint for each of the plurality of the reference viewpoints are acquired; and in a case where, at a time different from the predetermined time, the listening position is out of the region including the listening position at the predetermined time, the position information of the object of the listening position is calculated on the basis of the object position information of the plurality of the reference viewpoints forming the region including the listening position at the different time, or the position information of the object of the listening position obtained last is output.

BRIEF DESCRIPTION OF DRAWINGS

Fig. 1 is a diagram illustrating a configuration example of a content reproduction system.
Fig. 2 is a diagram illustrating an example of a system configuration information.
Fig. 3 is a diagram for describing coordinate transformation.
Fig. 4 is a diagram for describing coordinate axis transformation processing.
Fig. 5 is a diagram for describing interpolation processing.
Fig. 6 is a diagram for describing interpolation of object absolute coordinate position information.
Fig. 7 is a diagram for describing the internal division ratio in a triangle mesh on the viewpoint side.
Fig. 8 is a diagram for describing calculation of an object position by an internal division ratio.
Fig. 9 is a diagram for describing calculation of gain information by an internal division ratio.
Fig. 10 is a diagram illustrating a sequence example of a content reproduction system.
Fig. 11 is a diagram for describing a relationship between a listening position and a triangle mesh.
Fig. 12 is a diagram for describing a relationship between a listening position and a triangle mesh.
Fig. 13 is a diagram for describing the present technology.
Fig. 14 is a diagram illustrating a configuration of a content reproduction system.
Fig. 15 is a flowchart for describing system configuration information transmission processing and system configuration information reception processing.
Fig. 16 is a flowchart for describing viewpoint selection information transmission processing.
Fig. 17 is a flowchart for describing provision processing.
Fig. 18 is a flowchart for describing reproduction audio data generation processing.
Fig. 19 is a diagram for describing addition of a reference viewpoint.
Fig. 20 is a flowchart for describing viewpoint selection information transmission processing.
Fig. 21 is a flowchart for describing reproduction audio data generation processing.
Fig. 22 is a diagram for describing estimation of a transmission delay and addition of a reference viewpoint.
Fig. 23 is a flowchart for describing viewpoint selection information transmission processing.
Fig. 24 is a diagram illustrating a configuration example of a computer.

MODE FOR CARRYING OUT THE INVENTION

Hereinafter, embodiments to which the present technology is applied will be described with reference to the drawings.

<First embodiment>

<Configuration example of content reproduction system>

The present technology has the following features F1 to F3.

(Feature F1)

Object arrangement and gain information at a plurality of reference viewpoints in a free viewpoint space are prepared.

(Feature F2)

An object position and gain information at an arbitrary listening position are obtained on the basis of object arrangement and gain information at a plurality of reference viewpoints sandwiching or surrounding the arbitrary listening position.

(Feature F3)

In a case where an object position and gain information of an arbitrary listening position are obtained, a proportion ratio or an element similar to the proportion ratio is obtained from arbitrary listening position and a plurality of reference viewpoints sandwiching or surrounding the arbitrary listening position, and the object position and the gain information are obtained using the proportion ratio or the element similar to the proportion ratio.

First, a content reproduction system to which the present technology is applied will be described.

The content reproduction system includes a server and a client that perform coding, transmission, and decoding of each piece of data.

For example, as necessary, listener position information is transmitted from the client side to the server, and some object position information is transmitted from the server side to the client side on the basis of the listener position information. Then, rendering processing is performed on each object on the basis of some object position information received on the client side, and content including sound of each object is reproduced.

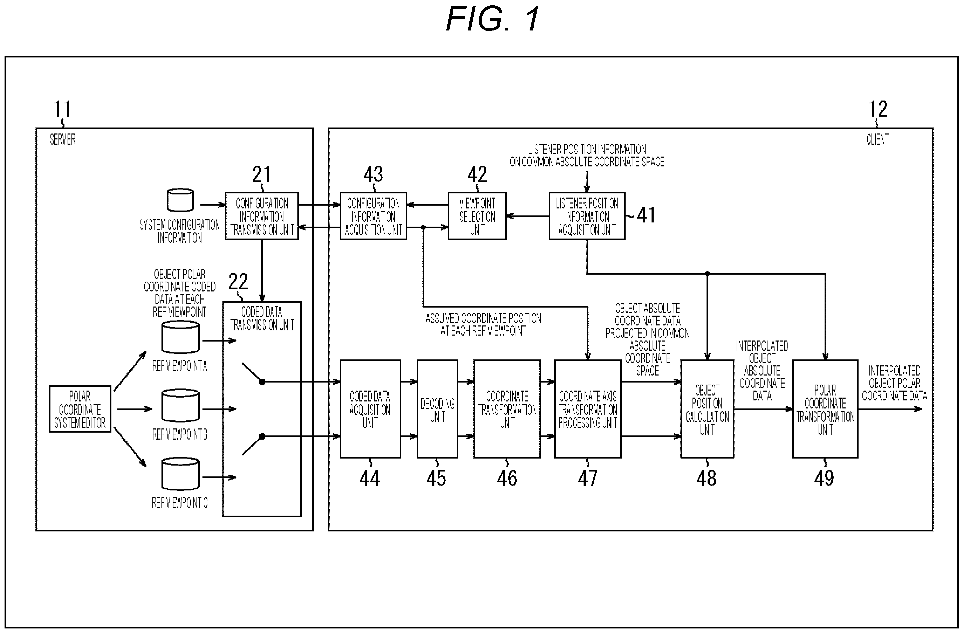

Such a content reproduction system is configured as illustrated in Fig. 1, for example.

That is, the content reproduction system illustrated in Fig. 1 includes a server 11 and a client 12.

The server 11 includes a configuration information transmission unit 21, and a coded data transmission unit 22.

The configuration information transmission unit 21 transmits (transmits) system configuration information prepared in advance to the client 12, or receives viewpoint selection information and the like transmitted from the client 12 to supply the viewpoint selection information and the like to the coded data transmission unit 22.

In the content reproduction system, a plurality of listening positions on a predetermined common absolute coordinate space is designated (set) in advance by a content creator as positions of reference viewpoints (hereinafter, also referred to as a reference viewpoint position).

Here, the content creator designates (sets) in advance, as the reference viewpoint, a position on the common absolute coordinate space that the content creator wants the listener to use as the listening position at the time of content reproduction, and a face orientation that the content creator wants the listener to face at the position, that is, a viewpoint from which the content creator wants the listener to listen to the sound of the content.

In the server 11, the system configuration information that is information associated with information regarding each reference viewpoint, and object polar coordinate coded data for each reference viewpoint are prepared.

Here, the object polar coordinate coded data for each reference viewpoint is obtained by coding object polar coordinate position information indicating a relative position of the object viewed from the reference viewpoint. In the object polar coordinate position information, the position of the object viewed from the reference viewpoint is expressed by polar coordinates. Note that even for the same object, the absolute arrangement position of the object in the common absolute coordinate space is different for each reference viewpoint.

The configuration information transmission unit 21 transmits the system configuration information to the client 12 via a network and the like immediately after the operation of the content reproduction system is started, that is, immediately after connection with the client 12 is established, for example.

The coded data transmission unit 22 transmits the object polar coordinate coded data of each of the plurality of reference viewpoints indicated by the viewpoint selection information supplied from the configuration information transmission unit 21, from among the plurality of reference viewpoints, to the client 12 via a network and the like.

Here, the viewpoint selection information is, for example, information indicating two or more reference viewpoints selected on the client 12 side.

Therefore, in the coded data transmission unit 22, the object polar coordinate coded data of the reference viewpoint requested by the client 12 is acquired, and is transmitted to the client 12.

Furthermore, the client 12 includes a listener position information acquisition unit 41, a viewpoint selection unit 42, a configuration information acquisition unit 43, a coded data acquisition unit 44, a decoding unit 45, a coordinate transformation unit 46, a coordinate axis transformation processing unit 47, an object position calculation unit 48, and a polar coordinate transformation unit 49.

The listener position information acquisition unit 41 acquires the listener position information indicating an absolute position (listening position) of the listener on the common absolute coordinate space according to a designation operation and the like of a user (listener) or the like, and supplies the listener position information to the viewpoint selection unit 42, the object position calculation unit 48, and the polar coordinate transformation unit 49.

For example, in the listener position information, the position of the listener in the common absolute coordinate space is expressed by absolute coordinates. Note that, hereinafter, the coordinate system of the absolute coordinates indicated by the listener position information is also referred to as a common absolute coordinate system.

The viewpoint selection unit 42 selects two or more reference viewpoints on the basis of the system configuration information supplied from the configuration information acquisition unit 43 and the listener position information supplied from the listener position information acquisition unit 41, and supplies viewpoint selection information indicating the selection result to the configuration information acquisition unit 43.

For example, the viewpoint selection unit 42 selects two or more reference viewpoints forming a predetermined range (region) including the listening position at a predetermined time, from among the plurality of reference viewpoints.

Specifically, for example, the viewpoint selection unit 42 selects two reference viewpoints sandwiching the listening position. In this case, the listening position is positioned on a section connecting the two selected reference viewpoints, that is, in a region (range) between the two reference viewpoints.

Furthermore, for example, the viewpoint selection unit 42 selects three reference viewpoints surrounding the listening position. In this case, the listening position is positioned in a triangular region (range) formed by the three selected reference viewpoints.

The configuration information acquisition unit 43 receives the system configuration information transmitted from the server 11 to supply the system configuration information to the viewpoint selection unit 42 and the coordinate axis transformation processing unit 47, or transmits the viewpoint selection information supplied from the viewpoint selection unit 42 to the server 11 via a network and the like.

Note that, here, an example in which the viewpoint selection unit 42 that selects the reference viewpoint on the basis of the listener position information and the system configuration information is provided in the client 12 will be described, but the viewpoint selection unit 42 may be provided on the server 11 side.

The coded data acquisition unit 44 receives the object polar coordinate coded data transmitted from the server 11, and supplies the object polar coordinate coded data to the decoding unit 45. That is, the coded data acquisition unit 44 acquires the object polar coordinate coded data from the server 11.

The decoding unit 45 decodes the object polar coordinate coded data supplied from the coded data acquisition unit 44, and supplies the object polar coordinate position information obtained as a result to the coordinate transformation unit 46.

The coordinate transformation unit 46 performs coordinate transformation on the object polar coordinate position information supplied from the decoding unit 45, and supplies the object absolute coordinate position information obtained as a result to the coordinate axis transformation processing unit 47.

The coordinate transformation unit 46 performs coordinate transformation that transforms polar coordinates into absolute coordinates. Therefore, the object polar coordinate position information as polar coordinates indicating the position of the object viewed from the reference viewpoint is transformed into the object absolute coordinate position information as absolute coordinates indicating the position of the object in the absolute coordinate system having the position of the reference viewpoint as the origin.

The coordinate axis transformation processing unit 47 performs coordinate axis transformation processing on the object absolute coordinate position information supplied from the coordinate transformation unit 46 on the basis of the system configuration information supplied from the configuration information acquisition unit 43.

Here, the coordinate axis transformation processing is processing performed by combining the coordinate transformation (coordinate axis transformation) and offset shift, and the object absolute coordinate position information indicating the absolute coordinates of the object projected in the common absolute coordinate space is obtained by the coordinate axis transformation processing. That is, the object absolute coordinate position information obtained by the coordinate axis transformation processing is absolute coordinates of the common absolute coordinate system, indicating the absolute position of the object on the common absolute coordinate space.

The object position calculation unit 48 performs interpolation processing on the basis of the listener position information supplied from the listener position information acquisition unit 41 and the object absolute coordinate position information supplied from the coordinate axis transformation processing unit 47, and supplies final object absolute coordinate position information obtained as a result to the polar coordinate transformation unit 49.

The final object absolute coordinate position information here is information indicating the position of the object in the common absolute coordinate system in a case where the viewpoint of the listener is at the listening position indicated by the listener position information.

On the other hand, the object absolute coordinate position information output from the coordinate axis transformation processing unit 47 is information indicating the position of the object in the common absolute coordinate system in a case where the viewpoint of the listener is at the reference viewpoint.

The object position calculation unit 48 calculates the absolute position of the object in the common absolute coordinate space corresponding to the listening position, that is, the absolute coordinates of the common absolute coordinate system, from the listening position indicated by the listener position information and the positions of the plurality of reference viewpoints indicated by the viewpoint selection information, and determines the absolute position as the final object absolute coordinate position information. At this time, the object position calculation unit 48 acquires the system configuration information from the configuration information acquisition unit 43 or acquires the viewpoint selection information from the viewpoint selection unit 42 as necessary.

The polar coordinate transformation unit 49 performs polar coordinate transformation on the object absolute coordinate position information supplied from the object position calculation unit 48 on the basis of the listener position information supplied from the listener position information acquisition unit 41, and outputs the polar coordinate position information obtained as a result to a rendering processing unit (not illustrated) at a subsequent stage.

The polar coordinate transformation unit 49 performs polar coordinate transformation of transforming the object absolute coordinate position information, which is absolute coordinates of the common absolute coordinate system, into the polar coordinate position information, which is polar coordinates indicating a relative position of the object viewed from the listening position.

Note that, the example in which the object polar coordinate coded data is prepared for each reference viewpoint in the server 11 has been described above, but the object absolute coordinate position information to be the output of the coordinate axis transformation processing unit 47 may be prepared in the server 11.

In such a case, the client 12 is configured not to include the coordinate transformation unit 46 and the coordinate axis transformation processing unit 47.

Then, the coded data acquisition unit 44 receives the object absolute coordinate coded data transmitted from the server 11, and supplies the object absolute coordinate coded data to the decoding unit 45. Furthermore, the decoding unit 45 decodes the object absolute coordinate coded data supplied from the coded data acquisition unit 44, and supplies the object absolute coordinate position information obtained as a result to the object position calculation unit 48.

Next, the content reproduction system and the like will be further described.

First, a process of producing content provided from the server 11 to the client 12 will be described.

Content production in the polar coordinate system is performed by 3D audio and the like based on a fixed viewpoint, and the content reproduction system of the present technology has an advantage that such a production method can be used as it is.

A plurality of reference viewpoints that the content creator (hereinafter, simply referred to as a producer) wants the listener to listen to is set in the three-dimensional space according to the intention of the content creator.

The reference viewpoint information, which is information associated with information regarding each reference viewpoint, includes reference viewpoint position information, which is absolute coordinates of the common absolute coordinate system indicating a standing position in the common absolute coordinate space, that is, a position of the reference viewpoint, and listener orientation information indicating the face orientation of the listener, but other data may be a component.

Here, the listener orientation information includes, for example, a rotation angle (horizontal angle) of the face of the listener in the horizontal direction at the reference viewpoint, and a vertical angle indicating the orientation of the face of the listener in the vertical direction.

Next, the object polar coordinate position information representing the position of each object at each of the plurality of set reference viewpoints in a polar coordinate format, and the gain amount (gain information) for each object at each of the reference viewpoints are set by the producer.

For example, the object polar coordinate position information includes the horizontal angle and the vertical angle indicating the position of the object based on the reference viewpoint, and a radius indicating the distance from the reference viewpoint to the object.

In a case where the position and the like of the object are set for each of the plurality of reference viewpoints in this manner, the following information IFP1 to information IFP5 are obtained as the information associated with information regarding the reference viewpoint.

(Information IFP1)

Number objects

(Information IFP2)

Number of reference viewpoints

(Information IFP3)

Face orientation (horizontal angle, vertical angle) of listener at reference viewpoint

(Information IFP4)

Absolute coordinate position at reference viewpoint in absolute space (common absolute coordinate space)

(Information IFP5)

Polar coordinate position (horizontal angle, vertical angle, radius) and gain amount of each object viewed from information IFP3 and information IFP4

Here, the information IFP3 is the listener orientation information described above, and the information IFP4 is the reference viewpoint position information described above.

Furthermore, the polar coordinate position as the information IFP5 includes the horizontal angle, the vertical angle, and the radius, and is object polar coordinate position information indicating the relative position of the object based on the reference viewpoint. Since the object polar coordinate position information is equivalent to the polar coordinate coded information of Moving Picture Experts Group (MPEG)-H, the coding system of MPEG-H can be utilized.

Among the information IFP1 to the information IFP5, information including the information IFP1 to the information IFP4 is the system configuration information described above.

This system configuration information is transmitted to the client 12 side prior to transmission of data related to the object, that is, the object polar coordinate coded data or coded audio data obtained by coding audio data of the object.

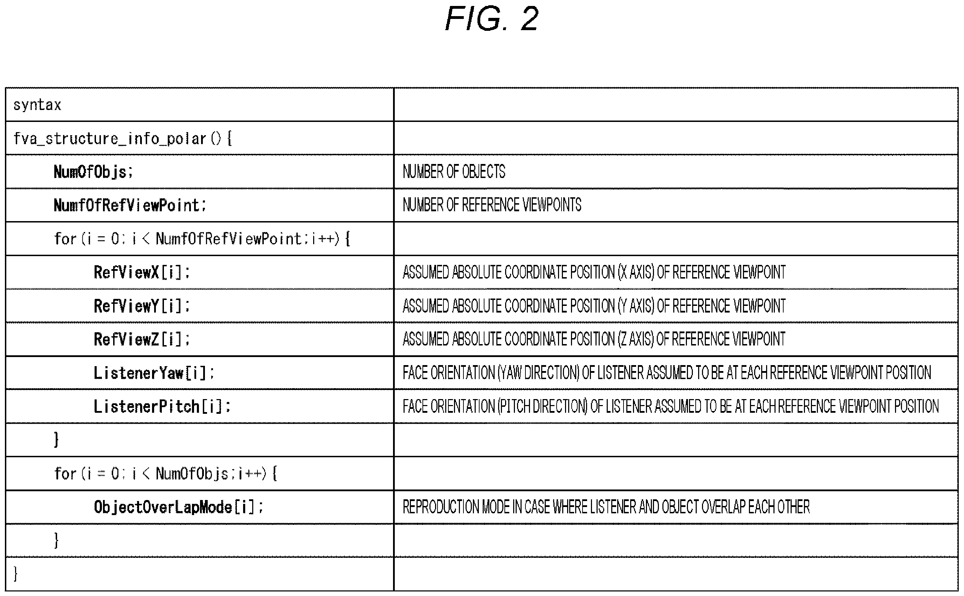

A specific example of the system configuration information is as illustrated in Fig. 2, for example.

In Fig. 2, "NumOfObjs" indicates the number of objects which is the number of objects constituting the content, that is, the information IFP1 described above, and "NumfOfRefViewPoint" indicates the number of reference viewpoints, that is, the information IFP2 described above.

Furthermore, the system configuration information includes the reference viewpoint information by the number of reference viewpoints "NumfOfRefViewPoint".

That is, "RefViewX[i]", "RefViewY[i]", and "RefViewZ[i]" indicate the X coordinate, the Y coordinate, and the Z coordinate of the common absolute coordinate system indicating the position of the reference viewpoint constituting the reference viewpoint position information of the i-th reference viewpoint as the information IFP4, respectively.

Furthermore, "ListenerYaw[i]" and "ListenerPitch[i]" are the horizontal angle (yaw angle) and the vertical angle (pitch angle) constituting the listener orientation information of the i-th reference viewpoint as the information IFP3.

Moreover, in this example, the system configuration information includes information "ObjectOverLapMode[i]" indicating a reproduction mode in a case where the positions of the listener and the object overlap with each other for each object, that is, the listener (listening position) and the object are at the same position.

The system configuration information obtained as described above, the object polar coordinate coded data of each object for each reference viewpoint, and the coded gain information obtained by coding the gain information indicating the gain amount are held in the server 11.

For example, in a streaming service and the like using free viewpoint audio, in a case where the operation of the content reproduction system is started, the server 11 transmits the system configuration information to the client 12 side prior to the transmission of the object polar coordinate coded data. Therefore, the client 12 side can grasp the number of objects constituting the content, the number of reference viewpoints, the position of the reference viewpoint in the common absolute coordinate space, and the like.

Next, the client 12 selects the reference viewpoint according to the listener position information, and transmits the viewpoint selection information indicating the selection result to the server 11.

Then, the server 11 transmits the object polar coordinate coded data and the coded gain information of the reference viewpoint requested by the viewpoint selection information to the client 12.

On the client 12 side, the object absolute coordinate position information and the gain information at an arbitrary viewpoint of the current listener are calculated by the interpolation processing and the like on the basis of the object polar coordinate coded data and the coded gain information at each of the plurality of reference viewpoints, and the listener position information.

Here, a specific example of calculation of the final object absolute coordinate position information and the gain information at an arbitrary viewpoint of the current listener will be described.

First, an example in which the viewpoint selection information is information indicating two reference viewpoints sandwiching the listener will be described.

In such a case, the client 12 performs the following processing PC1 to processing PC4 in order to obtain the final object absolute coordinate position information and the gain information at the viewpoint of the listener.

(Processing PC1)

In the processing PC1, the coordinate transformation unit 46 performs coordinate transformation on the object polar coordinate position information of each object for each reference viewpoint to generate the object absolute coordinate position information.

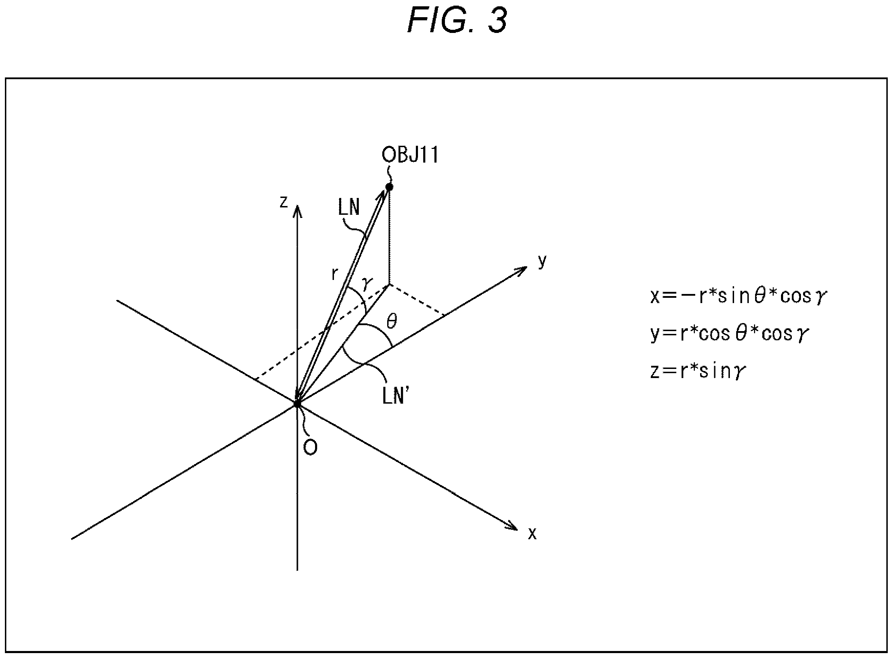

For example, as illustrated in Fig. 3, it is assumed that there is one object OBJ11 in a space of the polar coordinate system based on the origin O. Furthermore, a three-dimensional orthogonal coordinate system (absolute coordinate system) with the origin O as a reference (origin) and the x axis, the y axis, and the z axis as respective axes is referred to as an xyz coordinate system.

In this case, the position of the object OBJ11 in the polar coordinate system can be represented by polar coordinates including a horizontal angle θ which is an angle in the horizontal direction, a vertical angle γ which is an angle in the vertical direction, and a radius r indicating a distance from the origin O to the object OBJ11. In this example, polar coordinates (θ, γ, r) are the object polar coordinate position information of the object OBJ11.

Note that the horizontal angle θ is an angle in the horizontal direction starting from the origin O, that is, the front of the listener. In this example, in a case where a straight line (line segment) connecting the origin O and the object OBJ11 is LN, and a straight line obtained by projecting the straight line LN on the xy plane is LN', an angle formed by the y axis and the straight line LN' is the horizontal angle θ.

Furthermore, the vertical angle γ is an angle in the vertical direction starting from the origin O, that is, the front of the listener, and in this example, an angle formed by the straight line LN and the xy plane is the vertical angle γ. Moreover, the radius r is a distance from the listener (origin O) to the object OBJ11, that is, the length of the straight line LN.

In a case where the position of such an object OBJ11 is expressed by coordinates (x, y, z) of the xyz coordinate system, that is, absolute coordinates, the position is expressed by the following Expression (1).

[Expression 1]

$$x = -r * \sin\theta * \cos\gamma$$
$$y = r * \cos\theta * \cos\gamma$$
$$z = r * \sin\gamma \qquad \cdots (1)$$

In the processing PC1, Expression (1) is calculated on the basis of the object polar coordinate position information that is polar coordinates, and thereby the object absolute coordinate position information that is absolute coordinates indicating the position of the object in the xyz coordinate system (absolute coordinate system) in which the position of the reference viewpoint is the origin O is calculated.

In particular, in the processing PC1, for each of the two reference viewpoints, coordinate transformation is performed on the object polar coordinate position information of each of the plurality of objects at the reference viewpoint.

(Processing PC2)

In the processing PC2, for each of the two reference viewpoints, the coordinate axis transformation processing unit 47 performs coordinate axis transformation processing on the object absolute coordinate position information obtained in the processing PC1 for each object.

The object absolute coordinate position information at each of the two reference viewpoints obtained in the processing PC1 indicates the position in the xyz coordinate system with each of the reference viewpoints as the origin O. Therefore, the coordinates (coordinate system) of the object absolute coordinate position information are different for each reference viewpoint.

Therefore, coordinate axis transformation processing of integrating the object absolute coordinate position information at each reference viewpoint into absolute coordinates of one common absolute coordinate system, that is, absolute coordinates in the common absolute coordinate system (common absolute coordinate space) is performed as the processing PC2.

In order to perform the coordinate axis transformation processing, the reference viewpoint position information and the listener orientation information at each reference viewpoint are required in addition to the object absolute coordinate position information of each object for each reference viewpoint.

That is, the coordinate axis transformation processing requires the object absolute coordinate position information obtained by the processing PC1 and the system configuration information including the reference viewpoint position information indicating the position of the reference viewpoint in the common absolute coordinate system and the listener orientation information at the reference viewpoint.

Note that, in order to simplify the description, only the rotation angle in the horizontal direction is used as the face orientation indicated by the listener orientation information, but information of face up and down (pitch) can also be added.

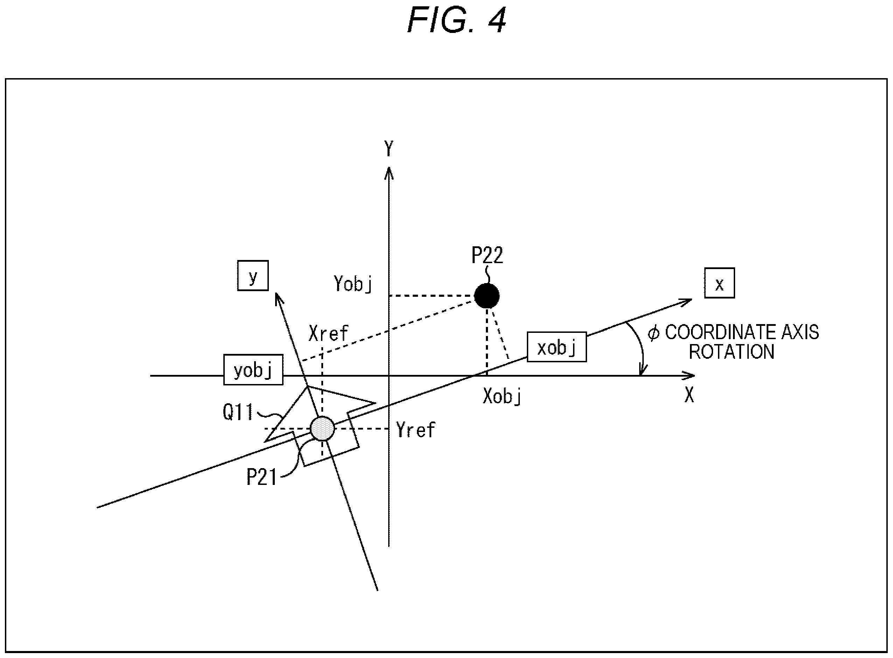

Now, in a case where the common absolute coordinate system is an XYZ coordinate system with the X axis, the Y axis, and the Z axis as respective axes, and the rotation angle according to the face orientation indicated by the listener orientation information is φ, for example, coordinate axis transformation processing is performed as illustrated in Fig. 4.

That is, in the example illustrated in Fig. 4, as the coordinate axis transformation processing, the coordinate axis rotation of rotating the coordinate axis by the rotation angle $\varphi$, processing of shifting the origin of the coordinate axis from the position of the reference viewpoint to the origin position of the common absolute coordinate system, more specifically, processing of shifting the position of the object according to the positional relationship between the reference viewpoint and the origin of the common absolute coordinate system are performed.

In Fig. 4, a position P21 indicates the position of the reference viewpoint, and an arrow Q11 indicates the face orientation of the listener indicated by the listener orientation information at the reference viewpoint. In particular, here, the X coordinate and the Y coordinate of the position P21 in the common absolute coordinate system (XYZ coordinate system) are (Xref, Yref) .

Furthermore, a position P22 indicates the position of the object when the reference viewpoint is at the position P21. Here, the X coordinate and the Y coordinate of the common absolute coordinate system indicating the position P22 of the object are (Xobj, Yobj), and the x coordinate and the y coordinate of the xyz coordinate system indicating the position P22 of the object and having the reference viewpoint as the origin are (xobj, yobj).

Moreover, in this example, the angle $\varphi$ formed by the X axis of the common absolute coordinate system (XYZ coordinate system) and the x axis of the xyz coordinate system is the rotation angle $\varphi$ of the coordinate axis transformation obtained from the listener orientation information.

Therefore, for example, the coordinate axis X (X coordinate) and the coordinate axis Y (Y coordinate) after the transformation are as illustrated in the following Expression (2).

[Expression 2]

$$X = X \text{ coordinate value of reference viewpoint} + x^*\cos(\phi) + y^*\sin(\phi)$$

$$Y = Y \text{ coordinate value of reference viewpoint} - x^*\sin(\phi) + y^*\cos(\phi)$$

$$\cdots (2)$$

Note that in Expression (2), x and y indicate the x axis (x coordinate) and the y axis (y coordinate) before the transformation, that is, in the xyz coordinate system. Furthermore, "reference viewpoint X coordinate value" and "reference viewpoint Y coordinate value" in Expression (2) indicate the X coordinate and the Y coordinate indicating the position of the reference viewpoint in the XYZ coordinate system (common absolute coordinate system), that is, the X coordinate and the Y coordinate constituting the reference viewpoint position information.

Therefore, in the example in Fig. 4, the X coordinate value Xobj and the Y coordinate value Yobj indicating the position of the object after the coordinate axis transformation processing can be obtained from Expression (2).

That is, $\varphi$ in Expression (2) is set as the rotation angle $\varphi$ obtained from the listener orientation information at the position P21, and the X coordinate value Xobj can be obtained by substituting "Xref", "xobj", and "yobj" for "reference viewpoint X coordinate value", "x", and "y" in Formula Expression (2), respectively.

Furthermore, $\varphi$ in Expression (2) is set as the rotation angle $\varphi$ obtained from the listener orientation information at the position P21, and the Y coordinate value Yobj can be obtained by substituting "Yref", "xobj", and "yobj" for "reference viewpoint Y coordinate value", "x", and "y" in Formula Expression (2), respectively.

Similarly, for example, in a case where two reference viewpoints A and B are selected by the viewpoint selection information, the X coordinate value and the Y coordinate value indicating the position of the object after the coordinate axis transformation processing for those reference viewpoints are as illustrated in the following Expression (3).

[Expression 3]

$$xa = X \text{ coordinate value of reference viewpoint A} + x^*\cos(\phi a) + y^*\sin(\phi a)$$

$$ya = Y \text{ coordinate value of reference viewpoint A} - x^*\sin(\phi a) + y^*\cos(\phi a)$$

$$xb = X \text{ coordinate value of reference viewpoint B} + x^*\cos(\phi b) + y^*\sin(\phi b)$$

$$yb = Y \text{ coordinate value of reference viewpoint B} - x^*\sin(\phi b) + y^*\cos(\phi b)$$

$$\cdots (3)$$

Note that, in Expression (3), xa and ya indicate the X coordinate value and the Y coordinate value of the XYZ coordinate system after the axis transformation (after the coordinate axis transformation processing) for the reference viewpoint A, and $\varphi a$ indicates the rotation angle of the axis transformation for the reference viewpoint A, that is, the above-described rotation angle $\varphi$.

Therefore, in a case where the x coordinate and the y coordinate constituting the object absolute coordinate position information at the reference viewpoint A obtained in the processing PC1 are substituted into Expression (3), a coordinate xa and a coordinate ya are obtained as the X coordinate and the Y coordinate indicating the position of the object in the XYZ coordinate system (common absolute coordinate system) at the reference viewpoint A. The absolute coordinates including the coordinate xa and the coordinate ya obtained in this manner and the Z coordinate are the object absolute coordinate position information output from the coordinate axis transformation processing unit 47.

Note that, in this example, since only the rotation angle $\varphi$ in the horizontal direction is used, coordinate axis transformation is not performed for the Z axis (Z coordinate). Therefore, for example, the z coordinate constituting the object absolute coordinate position information obtained in the processing PC1 is only required to be directly used as the Z coordinate indicating the position of the object in the common absolute coordinate system.

Similar to the reference viewpoint A, in Expression (3), xb and yb indicate the X coordinate value and the Y coordinate value of the XYZ coordinate system after the axis transformation (after the coordinate axis transformation processing) for the reference viewpoint B, and $\varphi$b indicates the rotation angle (rotation angle $\varphi$) of the axis transformation for the reference viewpoint B.

In the coordinate axis transformation processing unit 47, the coordinate axis transformation processing as described above is performed as the processing PC2.

(Processing PC3)

In the processing PC3, a proportion ratio for the interpolation processing is obtained from the absolute coordinate positions of the two reference viewpoints, that is, the positional relationship between the position indicated by the reference viewpoint position information included in the system configuration information and an arbitrary listening position sandwiched between the positions of the two reference viewpoints.

That is, the object position calculation unit 48 performs processing of obtaining the proportion ratio (m:n) as the processing PC3 on the basis of the listener position information supplied from the listener position information acquisition unit 41 and the reference viewpoint position information included in the system configuration information.

Here, it is assumed that the reference viewpoint position information indicating the position of the first reference viewpoint A is (x1, y1, z1), the reference viewpoint position information indicating the position of the second reference viewpoint B is (x2, y2, z2), and the listener position information indicating the listening position is (x3, y3, z3).

In this case, the object position calculation unit 48 calculates the proportion ratio (m:n), that is, m and n of the proportion ratio by calculating the following Expression (4).

[Expression 4]

$$m = SQRT\ ((x3-x1)*(x3-x1) + (y3-y1)*(y3-y1) + (z3-z1)*(z3-z1))$$
$$n = SQRT\ ((x3-x2)*(x3-x2) + (y3-y2)*(y3-y2) + (z3-z2)*(z3-z2))$$

$$\cdots (4)$$

(Processing PC4)

Subsequently, the object position calculation unit 48 performs interpolation processing as the processing PC4 on the basis of the proportion ratio (m:n) obtained by the processing PC3 and the object absolute coordinate position information of each object of the two reference viewpoints supplied from the coordinate axis transformation processing unit 47.

That is, in the processing PC4, by applying the proportion ratio (m:n) obtained in the processing PC3 to the same object corresponding to the two reference viewpoints obtained in the processing PC2, the object position and the gain amount corresponding to an arbitrary listening position are obtained.

Here, it is assumed that the object absolute coordinate position information of a predetermined object at the reference viewpoint A obtained by the processing PC2 is (xa, ya, za), and the gain amount indicated by the gain information of the predetermined object for the reference viewpoint A is g1.

Similarly, it is assumed that the object absolute coordinate position information of a predetermined object at the reference viewpoint B obtained by the processing PC2 is (xb, yb, zb), and the gain amount indicated by the gain information of the object for the reference viewpoint B is g2.

Furthermore, the absolute coordinates and the gain amount indicating the position of the predetermined object in the XYZ coordinate system (common absolute coordinate system) corresponding to an arbitrary listening position between the reference viewpoint A and the reference viewpoint B are (xc, yc, zc) and gain_c. The absolute coordinates (xc, yc, zc) are final object absolute coordinate position information output from the object position calculation unit 48 to the polar coordinate transformation unit 49.

At this time, the final object absolute coordinate position information (xc, yc, zc) and the gain amount gain_c for the predetermined object can be obtained by calculating the following Expression (5) using the proportion ratio (m:n).

[Expression 5]

$$xc = (m^*xb + n^*xa) / (m+n)$$
$$yc = (m^*yb + n^*ya) / (m+n)$$
$$zc = (m^*zb + n^*za) / (m+n)$$
$$gain\_c = (m^*g2 + n^*g1) / (m+n) \qquad \cdots (5)$$

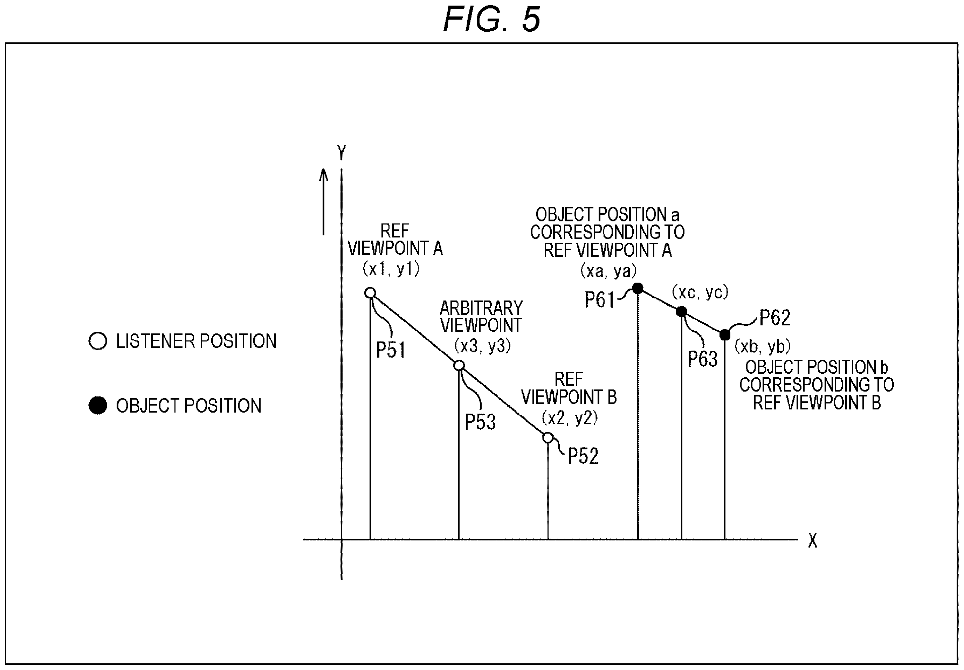

The positional relationship among the reference viewpoint A, the reference viewpoint B, and the listening position described above, and the positional relationship among the same object at the respective positions of the reference viewpoint A, the reference viewpoint B, and the listening position are as illustrated in Fig. 5.

In Fig. 5, the horizontal axis and the vertical axis indicate the X axis and the Y axis of the XYZ coordinate system (common absolute coordinate system), respectively. Note that, in order to simplify the description, only the X-axis direction and the Y-axis direction are illustrated.

In this example, a position P51 is a position indicated by the reference viewpoint position information (x1, y1, z1) of the reference viewpoint A, and a position P52 is a position indicated by the reference viewpoint position information (x2, y2, z2) of the reference viewpoint B.

Furthermore, a position P53 between the reference viewpoint A and the reference viewpoint B is a listening position indicated by the listener position information (x3, y3, z3).

In Expression (4) described above, the proportion ratio (m:n) is obtained on the basis of the positional relationship among the reference viewpoint A, the reference viewpoint B, and the listening position.

Furthermore, a position P61 is a position indicated by the object absolute coordinate position information (xa, ya, za) at the reference viewpoint A, and a position P62 is a position indicated by the object absolute coordinate position information (xb, yb, zb) at the reference viewpoint B.

Moreover, a position P63 between the position P61 and the position P62 is a position indicated by the object absolute coordinate position information (xc, yc, zc) at the listening position.

By performing the calculation of Expression (5), that is, the interpolation processing in this manner, object absolute coordinate position information indicating an appropriate object position can be obtained for an arbitrary listening position.

Note that the example of obtaining the object position, that is, the final object absolute coordinate position information using the proportion ratio (m:n) has been described above, but the present disclosure is not limited thereto, and the final object absolute coordinate position information may be estimated using machine learning and the like.

The two-point interpolation using the information of the two reference viewpoints has been described above.

Next, a specific example in a case where three-point interpolation using information of three reference viewpoints is performed will be described.

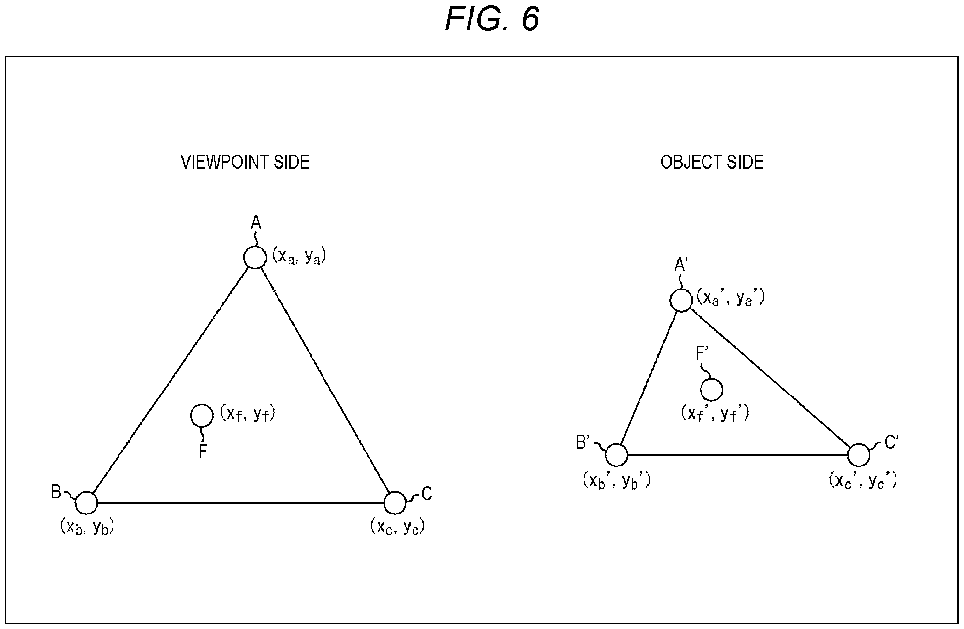

For example, as illustrated on the left side of Fig. 6, it is considered that the object absolute coordinate position information at an arbitrary listening position F is obtained by interpolation processing.

In this example, there are three reference viewpoint A, reference viewpoint B, and reference viewpoint C so as to surround the listening position F, and here, it is assumed that the interpolation processing is performed using the information of the reference viewpoint A to the reference viewpoint C.

Hereinafter, it is assumed that the X coordinate and the Y coordinate of the listening position F in the common absolute coordinate system, that is, the XYZ coordinate system, are $(x_f, y_f)$.

Similarly, it is assumed that the X coordinates and the Y coordinates of the positions of the reference viewpoint A, the reference viewpoint B, and the reference viewpoint C are $(x_a, y_a)$, $(x_b, y_b)$, and $(x_c, y_c)$, respectively.

In this case, as illustrated on the right side of Fig. 6, an object position F' at the listening position F is obtained on the basis of the coordinates of an object position A', an object position B', and an object position C' respectively corresponding to the reference viewpoint A, the reference viewpoint B, and the reference viewpoint C.

Here, for example, the object position A' indicates the position of the object when the viewpoint is at the reference viewpoint A, that is, the position of the object in the common absolute coordinate system indicated by the object absolute coordinate position information of the reference viewpoint A.

Furthermore, the object position F' indicates the position of the object in the common absolute coordinate system when the listener is at the listening position F, that is, the position indicated by the object absolute coordinate position information that is the output of the object position calculation unit 48.

Hereinafter, it is assumed that the X coordinates and the Y coordinates of the object position A', the object position B', and the object position C' are $(x_a', y_a')$, $(x_b', y_b')$, and $(x_c', y_c')$, respectively, and the X coordinate and the Y coordinate of the object position F' are $(x_f', y_f')$.

Furthermore, hereinafter, a triangular region surrounded by arbitrary three reference viewpoints such as the reference viewpoint A to the reference viewpoint C, that is, a triangular region formed by the three reference viewpoints is also referred to as a triangle mesh. For example, a triangle mesh formed by the reference viewpoint A to the reference viewpoint C is referred to as a triangle mesh ABC or the like.

Since a plurality of reference viewpoints is present in the common absolute coordinate space, a plurality of triangle meshes having the reference viewpoint as a vertex can be formed in the common absolute coordinate space.

Similarly, hereinafter, a triangular region surrounded (formed) by the object positions indicated by the object absolute coordinate position information of arbitrary three reference viewpoints such as the object position A' to the object position C' is also referred to as a triangle mesh. For example, a triangle mesh formed by the object position A' to the object position C' is referred to as a triangle mesh A'B'C' or the like.

In the example of two-point interpolation described above, the listener can move to an arbitrary position on the line segment connecting the two reference viewpoints, and listen to the sound of the content.

On the other hand, in a case where three-point interpolation is performed, the listener can move to an arbitrary position in the region of the triangle mesh surrounded by the three reference viewpoints, and listen to the sound of the content. That is, a region other than the line segment connecting two reference viewpoints in the case of two-point interpolation can be covered as the listening position.

Similar to the case of two-point interpolation, even in a case where three-point interpolation is performed, coordinates indicating an arbitrary position in the common absolute coordinate system (XYZ coordinate system) can be obtained from the coordinates of the arbitrary position in the xyz coordinate system, the listener orientation information, and the reference viewpoint position information by the above-described Expression (2).

Note that, here, the Z coordinate value of the XYZ coordinate system is assumed to be the same as the z coordinate value of the xyz coordinate system, but in a case where the Z coordinate value and the z coordinate value are different, the Z coordinate value indicating an arbitrary position is only required to be obtained by adding the Z coordinate value indicating the position of the reference viewpoint in the XYZ coordinate system to the z coordinate value of the arbitrary position.

Ceva's theorem proves that an arbitrary listening position in a triangle mesh including three reference viewpoints is uniquely determined by an intersection of line segments from each of three vertices of the triangle mesh to each of internally dividing points of three sides not adjacent to the vertices in a case where the internal division ratio of each side of the triangle mesh is appropriately determined.

This is established in all the triangle meshes regardless of the shape of the triangle mesh in a case where the configuration of the internal division ratio of the three sides of the triangle mesh is determined from the proof formula.

Therefore, in a case where the internal division ratio of the triangle mesh including the listening position is obtained for the viewpoint side, that is, for the reference viewpoint, and the internal division ratio is applied to the object side, that is, the triangle mesh of the object position, an appropriate object position for an arbitrary listening position can be obtained.

Hereinafter, an example of obtaining the object absolute coordinate position information indicating the position of the object at the time of being in an arbitrary listening position, using such a property of the internal division ratio will be described.

In this case, first, the internal division ratio of the side of the triangle mesh of the reference viewpoint on the XY plane of the XYZ coordinate system, which is a two-dimensional space, is obtained.

Next, on the XY plane, the above-described internal division ratio is applied to the triangle mesh of the object positions corresponding to the three reference viewpoints, and the X coordinate and the Y coordinate of the position of the object corresponding to the listening position on the XY plane are obtained.

Moreover, the Z coordinate of the object corresponding to the listening position is obtained on the basis of a three-dimensional plane including the positions of the three objects corresponding to the three reference viewpoints in the three-dimensional space (XYZ coordinate system) and the X coordinate and the Y coordinate of the object at the listening position on the XY plane.

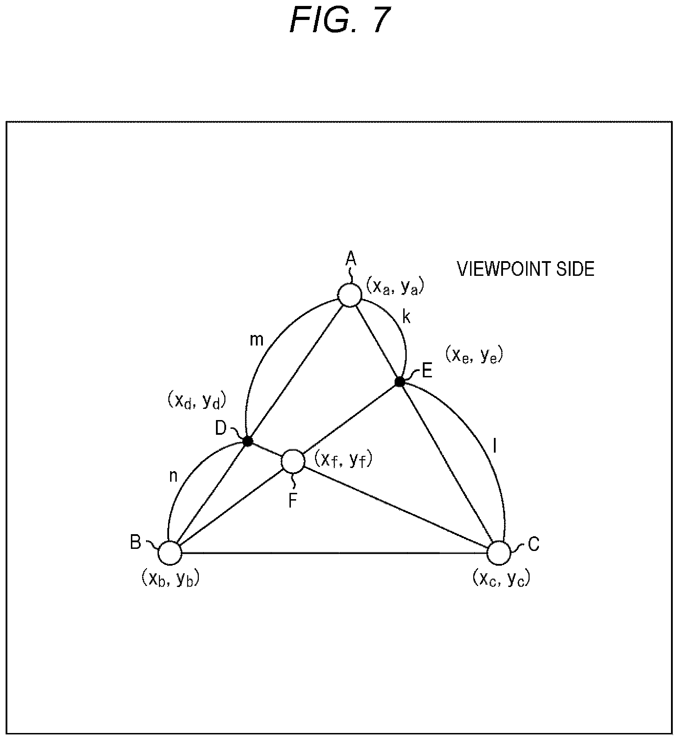

Here, an example of obtaining the object absolute coordinate position information and the gain information indicating the object position F' by the interpolation processing for the listening position F illustrated in Fig. 6 will be described with reference to Figs. 7 to 9.

For example, as illustrated in Fig. 7, first, the X coordinate and the Y coordinate of the internally dividing point in the triangle mesh including the reference viewpoint A to the reference viewpoint C, which includes the listening position F, are obtained.

Now, it is assumed that an intersection of a straight line passing through the listening position F and the reference viewpoint C and a line segment AB from the reference viewpoint A to the reference viewpoint B is a point D, and coordinates indicating the position of the point D on the XY plane are $(x_d, y_d)$. That is, the point D is an internally dividing point on the line segment AB (side AB).

At this time, the relationship illustrated in the following Expression (6) is established for the X coordinate and the Y coordinate indicating the position of an arbitrary point on a line segment CF from the reference viewpoint C to the listening position F, and the X coordinate and the Y coordinate indicating the position of an arbitrary point on the line segment AB.

[Expression 6]

$$\text{Line segment CF: } Y = \alpha_1 X - \alpha_1 x_c + y_c, \text{ where } \alpha_1 = (y_c - y_f)/(x_c - x_f)$$
$$\text{Line segment AB: } Y = \alpha_2 X - \alpha_2 x_a + y_a, \text{ where } \alpha_2 = (y_b - y_a)/(x_b - x_a)$$

$$\cdots (6)$$

Furthermore, since the point D is an intersection of the straight line passing through the reference viewpoint C and the listening position F and the line segment AB, coordinates $(x_d, y_d)$ of the point D on the XY plane can be obtained from Expression (6), and the coordinates $(x_d, y_d)$ are as illustrated in the following Expression (7).

[Expression 7]

$$x_d = (\alpha_1 x_c - y_c - \alpha_2 x_a + y_a)/(\alpha_1 - \alpha_2)$$
$$y_d = \alpha_1 x_d - \alpha_1 x_c + y_c \qquad \cdots (7)$$

Therefore, as illustrated in the following Expression (8), the internal division ratio (m, n) of the line segment AB by the point D, that is, the division ratio can be obtained on the basis of the coordinates $(x_d, y_d)$ of the point D, the coordinates $(x_a, y_a)$ of the reference viewpoint A, and the coordinates $(x_b, y_b)$ of the reference viewpoint B.

[Expression 8]

$$m = \text{sqrt}((x_a - x_d)^2 + (y_a - y_d)^2)$$
$$n = \text{sqrt}((x_b - x_d)^2 + (y_b - y_d)^2) \qquad \cdots (8)$$

Similarly, it is assumed that an intersection of a straight line passing through the listening position F and the reference viewpoint B and a line segment AC from the reference viewpoint A to the reference viewpoint C is a point E, and coordinates indicating the position of the point E on the XY plane are $(x_e, y_e)$. That is, the point E is an internally dividing point on the line segment AC (side AC).

At this time, the relationship illustrated in the following Expression (9) is established for the X coordinate and the Y coordinate indicating the position of an arbitrary point on a line segment BF from the reference viewpoint B to the listening position F, and the X coordinate and the Y coordinate indicating the position of an arbitrary point on the line segment AC.

[Expression 9]

$$\text{Line segment BF: } Y = \alpha_3 X - \alpha_3 x_b + y_b, \text{ where } \alpha_3 = (y_b - y_f)/(x_b - x_f)$$
$$\text{Line segment AC: } Y = \alpha_4 X - \alpha_4 x_a + y_a, \text{ where } \alpha_4 = (y_c - y_a)/(x_c - x_a)$$

$$\cdots (9)$$

Furthermore, since the point E is an intersection of the straight line passing through the reference viewpoint B and the listening position F and the line segment AC, coordinates $(x_e, y_e)$ of the point E on the XY plane can be obtained from Expression (9), and the coordinates $(x_e, y_e)$ are as illustrated in the following Expression (10).

[Expression 10]

$$x_e = (\alpha_3 x_b - y_b - \alpha_4 x_a + y_a) / (\alpha_3 - \alpha_4)$$
$$y_e = \alpha_3 x_e - \alpha_3 x_b + y_b \qquad \cdots (10)$$

Therefore, as illustrated in the following Expression (11), the internal division ratio (k, l) of the line segment AC by the point E, that is, the division ratio can be obtained on the basis of the coordinates $(x_e, y_e)$ of the point E, the coordinates $(x_a, y_a)$ of the reference viewpoint A, and the coordinates $(x_c, y_c)$ of the reference viewpoint C.
[Expression 11]

$$k = \mathrm{sqrt}((x_a - x_e)^2 + (y_a - y_e)^2)$$
$$l = \mathrm{sqrt}((x_c - x_e)^2 + (y_c - y_e)^2) \qquad \cdots (11)$$

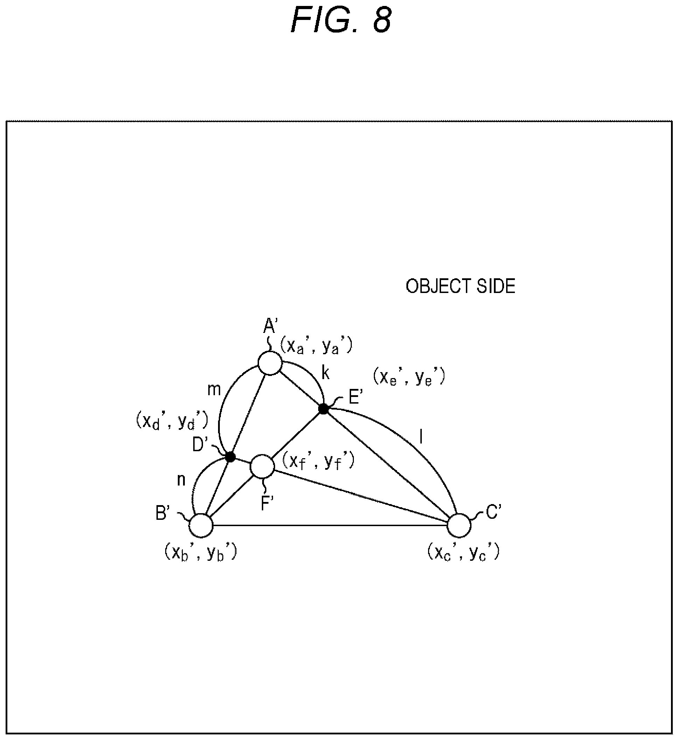

Next, by applying the ratios of two sides obtained in this manner, that is, the internal division ratio (m, n) and the internal division ratio (k, l) to the triangle mesh on the object side as illustrated in Fig. 8, coordinates $(x_f', y_f')$ of the object position F' on the XY plane are obtained.
Specifically, in this example, a point corresponding to the point D on a line segment A'B' connecting the object position A' and the object position B' is a point D'.
Similarly, a point corresponding to the point E on a line segment A'C' connecting the object position A' and the object position C' is a point E'.
Furthermore, an intersection between a straight line passing through the object position C' and the point D' and a straight line passing through the object position B' and the point E' is the object position F' corresponding to the listening position F.
Here, it is assumed that the internal division ratio of the line segment A'B' by the point D' is the same as the internal division ratio (m, n) at the point D. At this time, coordinates $(x_d', y_d')$ of the point D' on the XY plane can be obtained on the basis of the internal division ratio (m, n), the coordinates $(x_a', y_a')$ of the object position A', and the coordinates $(x_b', y_b')$ of the object position B', as illustrated in the following Expression (12).
[Expression 12]

$$x_d' = (n x_a' + m x_b') / (m + n)$$
$$y_d' = (n y_a' + m y_b') / (m + n) \qquad \cdots (12)$$

Furthermore, it is assumed that the internal division ratio of the line segment A'C' by the point E' is the same as the internal division ratio (k, l) at the point E. At this time, coordinates $(x_e', y_e')$ of the point E' on the XY plane can be obtained on the basis of the internal division ratio (k, l), the coordinates $(x_a', y_a')$ of the object position A', and the coordinates $(x_c', y_c')$ of the object position C', as illustrated in the following Expression (13).
[Expression 13]

$$x_e' = (l x_a' + k x_c') / (k + l)$$
$$y_e' = (l y_a' + k y_c') / (k + l) \qquad \cdots (13)$$

Therefore, the relationship illustrated in the following Expression (14) is established for the X coordinate and the Y coordinate indicating the position of an arbitrary point on a line segment B'E' from the object position B' to the point E', and the X coordinate and the Y coordinate indicating the position of an arbitrary point on a line segment C'D' from the object position C' to the point D'.
[Expression 14]

Line segment B'E': $Y = \alpha_5 X + y_b' - \alpha_5 x_b'$, where $\alpha_5 = (y_e' - y_b') / (x_e' - x_b')$
Line segment C'D': $Y = \alpha_6 X + y_c' - \alpha_6 x_c'$, where $\alpha_6 = (y_d' - y_c') / (x_d' - x_c')$

$$\cdots (14)$$

Since the target object position F' is the intersection of the line segment B'E' and the line segment C'D', the coordinates $(x_f', y_f')$ of the object position F' can be obtained by the following Expression (15) from the relationship of Expression (14).
[Expression 15]

$$x_f' = (-y_b' + \alpha_5 x_b' + y_c' - \alpha_6 x_c') / (\alpha_5 - \alpha_6)$$
$$y_f' = \alpha_6 x_f' + y_c' - \alpha_6 x_c' \qquad \cdots (15)$$

By the above processing, the coordinates $(x_f', y_f')$ of the object position F' on the XY plane are obtained.

Subsequently, coordinates $(x_f', y_f', z_f')$ of the object position F' in the XYZ coordinate system are obtained on the basis of the coordinates $(x_f', y_f')$ of the object position F' on the XY plane, and coordinates $(x_a', y_a', z_a')$ of the object position A', coordinates $(x_b', y_b', z_b')$ of the object position B', and coordinates $(x_c', y_c', z_c')$ of the object position C' in the XYZ coordinate system. That is, the Z coordinate $z_f'$ of the object position F' in the XYZ coordinate system is obtained.

For example, a triangle on a three-dimensional space having the object position A', the object position B', and the object position C' in the XYZ coordinate system (common absolute coordinate space) as vertices, that is, a three-dimensional plane A'B'C' including the object position A', the object position B', and the object position C' is obtained. Then, a point of which the X coordinate and the Y coordinate are $(x_f', y_f')$ on the three-dimensional plane A'B'C' is obtained, and the Z coordinate of the point is set as $z_f'$.

Specifically, a vector having the object position A' in the XYZ coordinate system as a start point and the object position B' as an end point is set as a vector

$$A'B' = (x_{ab}', y_{ab}', z_{ab}').$$

Similarly, a vector having the object position A' in the XYZ coordinate system as a start point and the object position C' as an end point is set as a vector

$$A'C' = (x_{ac}', y_{ac}', z_{ac}').$$

The vector A'B' and the vector A'C' can be obtained on the basis of the coordinates of the object position A' $(x_a', y_a', z_a')$, the coordinates of the object position B' $(x_b', y_b', z_b')$, and the coordinates of the object position C' $(x_c', y_c', z_c')$. That is, the vector A'B' and the vector A'C' can be obtained by the following Expression (16).
[Expression 16]

$$\text{Vector A'B'}: \quad (x_{ab}', y_{ab}', z_{ab}') = (x_b' - x_a', y_b' - y_a', z_b' - z_a')$$
$$\text{Vector A'C'}: \quad (x_{ac}', y_{ac}', z_{ac}') = (x_c' - x_a', y_c' - y_a', z_c' - z_a')$$
$$\cdots (16)$$

Furthermore, the normal vector (s, t, u) of the three-dimensional plane A'B'C' is an outer product of the vector A'B' and the vector A'C', and can be obtained by the following Expression (17).
[Expression 17]

$$(s, t, u) = (y_{ab}' z_{ac}' - z_{ab}' y_{ac}', z_{ab}' x_{ac}' - x_{ab}' z_{ac}', x_{ab}' y_{ac}' - y_{ab}' x_{ac}')$$
$$\cdots (17)$$

Therefore, from the normal vector (s, t, u) and the coordinates $(x_a', y_a', z_a')$ of the object position A', the plane equation of the three-dimensional plane A'B'C' is as illustrated in the following Expression (18).
[Expression 18]

$$s(X - x_a') + t(Y - y_a') + u(Z - z_a') = 0 \qquad \cdots (18)$$

Here, since the X coordinate $x_f'$ and the Y coordinate $y_f'$ of the object position F' on the three-dimensional plane A'B'C' have already been obtained, the Z coordinate $z_f'$ can be obtained as illustrated in the following Expression (19) by substituting the X coordinate $x_f'$ and the Y coordinate $y_f'$ for X and Y of the plane equation of Expression (18).
[Expression 19]

$$z_f' = (-s(x_f' - x_a') - t(y_f' - y_a'))/u + z_a' \qquad \cdots (19)$$

By the above calculation, the coordinates $(x_f', y_f', z_f')$ of the target object position F' are obtained. The object position calculation unit 48 outputs the object absolute coordinate position information indicating the coordinates $(x_f', y_f', z_f')$ of the object position F' obtained in this manner.

Furthermore, similar to the case of the object absolute coordinate position information, the gain information can also be obtained by three-point interpolation.

That is, the gain information of the object at the object position F' can be obtained by performing interpolation processing on the basis of the gain information of the object in a case where the viewpoint is at each of the reference viewpoint A to the reference viewpoint C.

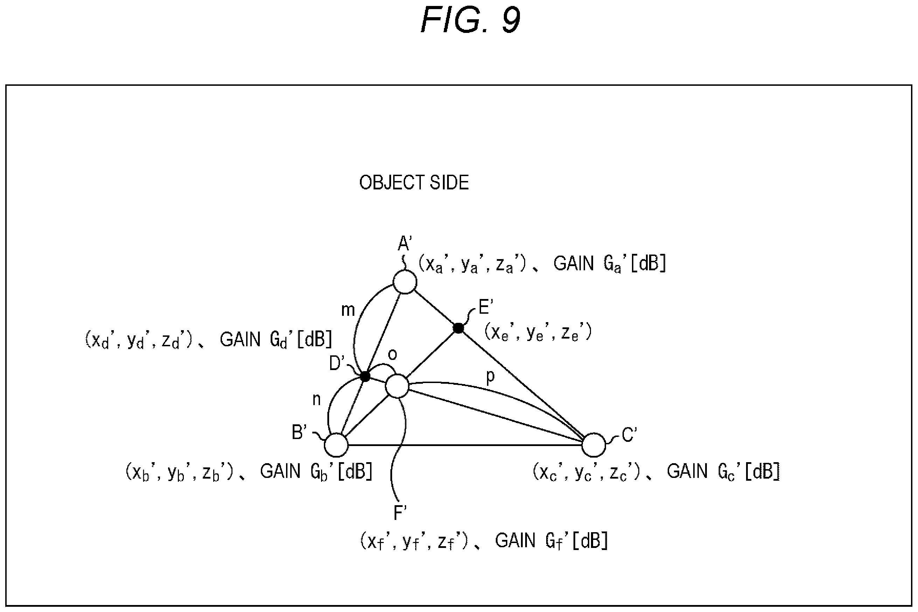

For example, as illustrated in Fig. 9, it is considered to obtain gain information $G_f'$ of the object at the object position F' in the triangle mesh formed by the object position A', the object position B', and the object position C'.

Now, it is assumed that gain information of the object at the object position A' in a case where the viewpoint is at the reference viewpoint A is $G_a'$, gain information of the object at the object position B' is $G_b'$, and gain information of the object at the object position C' is $G_c'$.

In this case, first, gain information $G_d'$ of the object at the point D' that is the internally dividing point of the line segment A'B' in a case where the viewpoint is virtually at the point D is obtained.

Specifically, the gain information $G_d'$ can be obtained by calculating the following Expression (20) on the basis of the internal division ratio (m, n) of the line segment A'B' described above, the gain information $G_a'$ of the object position A', and the gain information $G_b'$ of the object position B'.
[Expression 20]

$$G_d' = (m*G_b' + n*G_a')/(m+n) \qquad \cdots (20)$$

That is, in Expression (20), the gain information $G_d'$ of the point D' is obtained by interpolation processing based on the gain information $G_a'$ and the gain information $G_b'$.

Next, the gain information $G_f'$ of the object position F' is obtained by performing the interpolation processing on the basis of an internal division ratio (o, p) of the line segment C'D' from the object position C' to the point D' by the object position F', the gain information $G_c'$ of the object position C', and the gain information $G_d'$ of the point D'. That is, the gain information $G_f'$ is obtained by performing the calculation of the following Expression (21).
[Expression 21]

$$G_f' = (o*G_c' + p*G_d')/(o+p)$$
$$\text{where}$$
$$o = SQRT((x_d' - x_f')^2 + (y_d' - y_f')^2 + (z_d' - z_f')^2)$$
$$p = SQRT((x_c' - x_f')^2 + (y_c' - y_f')^2 + (z_c' - z_f')^2) \qquad \cdots (21)$$

The gain information $G_f'$ obtained in this manner is output from the object position calculation unit 48 as the gain information of the object corresponding to the listening position F.

By performing the three-point interpolation as described above, the object absolute coordinate position information and the gain information can be obtained for an arbitrary listening position. Note that, in the following description, it is basically assumed that three-point interpolation is performed.

<Regarding listener and object>

By the way, as the reference viewpoint, for example, two examples of a viewpoint assumed as a listener and a viewpoint assumed as a performer imagining becoming an object can be considered.

In the latter case, since the listener and the object overlap each other at the reference viewpoint, that is, the listener and the object are at the same position, the following cases CA1 to CA3 are considered.

(Case CA1)

Prohibit a listener from overlapping an object, or prohibit a listener from entering a specific range.

(Case CA2)

Sound generated from an object when a listener is assimilated with the object is output from all channels

(Case CA3)

Mute or attenuate sound generated from overlapping objects
For example, in the case CA2, the sense localized in the listener's head can be reproduced.
Furthermore, in the case CA3, by muting or attenuating the sound of the object, it is conceivable that the listener becomes a performer and uses the sound in a karaoke mode, for example. In this case, a surrounding accompaniment or the like other than the performer's singing voice surrounds the listener himself/herself, and the sense of singing therein can be obtained.
In a case where the content creator has such an intention, identifiers indicating the cases CA1 to CA3 can be stored in the coded bit stream transmitted from the server 11, and transmitted to the client 12 side. For example, such an identifier is information indicating the reproduction mode described above.

<Regarding operation of content reproduction system>

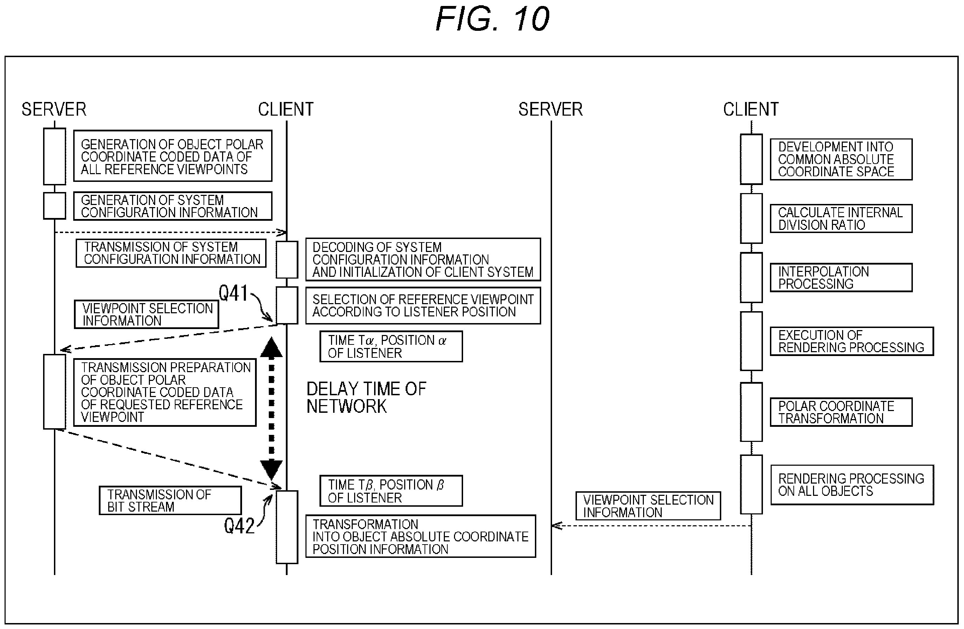

The content reproduction system described above can be applied to, for example, a system that distributes free viewpoint audio content using an Audio Artistic Intent. In this case, content distribution may be performed in real time, or archive content prepared in advance may be distributed (archive data transmission).
As described above, in the content reproduction system, a plurality of reference viewpoints created by a content creator is assumed, and information of object arrangement at the reference viewpoints, that is, system configuration information, object polar coordinate position information, and the like are created.
On the other hand, the listener can freely move to a position other than the reference viewpoint.
In a case where the listener is at a position other than the reference viewpoint, interpolation processing is performed on the basis of the object absolute coordinate position information of the plurality of reference viewpoints surrounding the position of the listener, and the object absolute coordinate position information corresponding to the current listener position is calculated. This enables spatial sound reproduction at a free viewpoint position while reflecting the intention of the content creator.
However, in a case where the object polar coordinate coded data corresponding to the reference viewpoint requested by the listener is transmitted, the arrival of the object polar coordinate coded data to the client 12 may be delayed due to a delay of the network and the like.
Then, on the client 12 side, an event occurs in which information on the position of an appropriate object corresponding to the current listening position cannot be obtained.
Hereinafter, an example of a flow (sequence) of processing performed in the content reproduction system and a transmission delay will be described with reference to Fig. 10.
For example, on the server 11 side, a polar coordinate system editor generates and holds the object polar coordinate coded data for all the reference viewpoints, and also generates and holds the system configuration information.
Then, the server 11 transmits the system configuration information to the client 12 via a network and the like, and the client 12 receives and holds the system configuration information. At this time, the client 12 decodes (decodes) the received system configuration information, and initializes a client system.
Subsequently, the client 12 selects a reference viewpoint necessary for the interpolation processing on the basis of the listener position information and the system configuration information, and transmits the viewpoint selection information indicating the selection result to the server 11, thereby requesting transmission of the object polar coordinate coded data.
For example, at the time of selecting the reference viewpoint, three reference viewpoints surrounding the listening position or two reference viewpoints sandwiching the listening position are selected. In other words, a plurality of reference viewpoints forming a range including the listening position, that is, a section sandwiching the listening position, or a region surrounding the listening position is selected.
Furthermore, the server 11 prepares for transmission of the object polar coordinate coded data of the reference viewpoint necessary for the interpolation processing, according to the viewpoint selection information received from the client 12.

That is, the server 11 reads and multiplexes the object polar coordinate coded data of the reference viewpoint indicated by the viewpoint selection information and the coded gain information to generate a bit stream. Then, the server 11 transmits (transmits) the generated bit stream to the client 12.

The client 12 receives the bit stream transmitted from the server 11, performs demultiplexing and decoding, and obtains the object polar coordinate position information and the gain information.

The client 12 transforms the object polar coordinate position information into the object absolute coordinate position information by performing coordinate transformation, and performs development into the common absolute coordinate space by coordinate axis transformation with respect to the object absolute coordinate position information.

Moreover, the client 12 calculates the internal division ratio or the proportion ratio for the interpolation processing from the current listener position and the position of the reference viewpoint, and performs the interpolation processing of the object absolute coordinate position information and the gain information. Therefore, the object absolute coordinate position information and the gain information corresponding to the current listener position are obtained.

Thereafter, the client 12 transforms the object absolute coordinate position information into the polar coordinate position information by the polar coordinate transformation, and performs rendering processing to which the obtained polar coordinate position information and gain information are applied.

For example, rendering processing in a polar coordinate system defined by MPEG-H, such as vector based amplitude panning (VBAP), is performed on all objects. Therefore, the reproduction audio data for reproducing the sound of the content is obtained.

In a case where the processing described above is performed on the predetermined frame to generate the reproduction audio data, the content reproduction based on the reproduction audio data is appropriately performed. Then, after that, new viewpoint selection information is appropriately transmitted from the client 12 to the server 11, and the processing described above is repeatedly performed.

As described above, the content reproduction system calculates the gain information and the information on the position of the object at an arbitrary listening position by the interpolation processing from the information on the position of the object for each of the plurality of reference viewpoints. In this way, it is possible to realize the object arrangement based on the intention of the content creator according to the listening position instead of the simple physical relationship between the listener and the object. Therefore, it is possible to realize the content reproduction based on the intention of the content creator, and to sufficiently deliver the amusement of the content to the listener.

However, in a case where the transmission delay in the network between the server 11 and the client 12 is large, the client 12 may not be able to obtain appropriate polar coordinate position information of the object.

For example, it is assumed that the time indicated by arrow Q41 at which the client 12 generates the viewpoint selection information is time $T\alpha$, and the listening position at time $T\alpha$ is a listening position $\alpha$. Furthermore, it is assumed that the time indicated by arrow Q42 at which the client 12 receives the object polar coordinate coded data (bit stream) is time $T\beta$, and the listening position at time $T\beta$ is the listening position $\beta$.

In this case, the time from time $T\alpha$ to time $T\beta$ is a delay time including a processing time in the server 11, a transmission delay in the network, and the like.

In a case where such a delay time is long, there is a possibility that the listener has moved from the listening position $\alpha$ at time $T\alpha$ to a different listening position $\beta$, and the object polar coordinate coded data received at time $T\beta$ is not appropriate for the listening position $\beta$ after the movement.

As a specific example, a case where three reference viewpoints surrounding the listening position are selected, that is, a case where three-point interpolation is performed will be described.

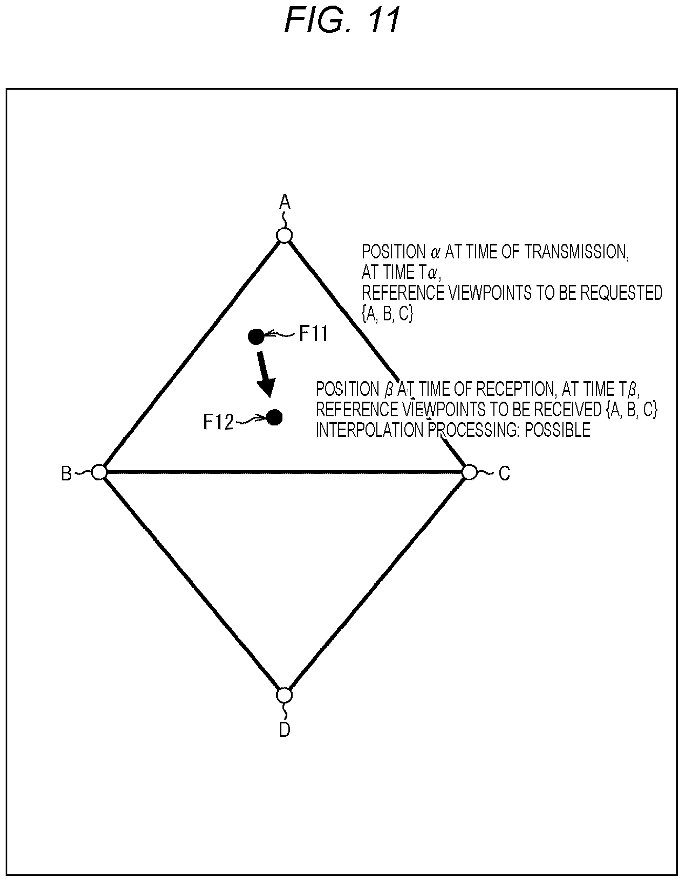

For example, as illustrated in Fig. 11, it is assumed that there are the triangle mesh ABC including the reference viewpoint A to the reference viewpoint C and a triangle mesh BCD including the reference viewpoint B to a reference viewpoint D.

Furthermore, it is also assumed that the listening position $\alpha$ at time $T\alpha$ is a position indicated by arrow F11.

In this case, since the listening position $\alpha$ is in the triangle mesh ABC, the viewpoint selection information indicating the reference viewpoint A, the reference viewpoint B, and the reference viewpoint C is generated at time $T\alpha$. Then, at time $T\beta$, the object polar coordinate coded data of the reference viewpoint A to the reference viewpoint C is received.

At this time, in a case where it is assumed that the listening position $\beta$ at time $T\beta$ is a position indicated by arrow F12, the listening position $\beta$ is within the triangle mesh ABC similar to the case of the listening position $\alpha$.

Therefore, in the interpolation processing for obtaining the final object absolute coordinate position information when the listener is at the listening position $\beta$, the object polar coordinate coded data of the reference viewpoint A to the reference viewpoint C is necessary.

Since the object polar coordinate coded data necessary for the interpolation processing when the listener is at the listening position $\beta$ is received at time $T\beta$, the client 12 can appropriately perform the interpolation processing to obtain the reproduction audio data.

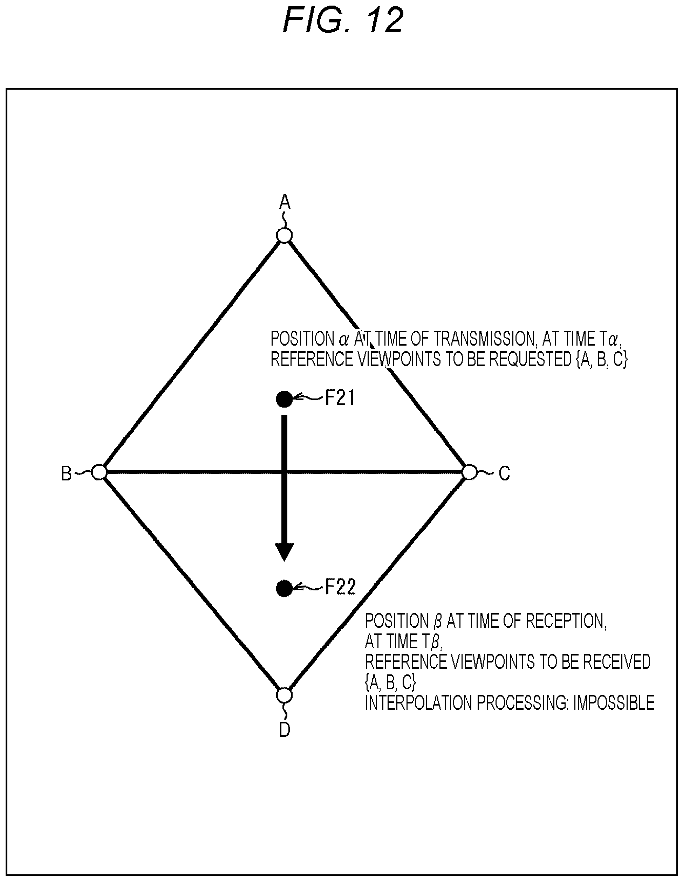

On the other hand, for example, as illustrated in Fig. 12, it is assumed that the listening position $\alpha$ at time $T\alpha$ is a position indicated by arrow F21, and the listening position $\beta$ at time $T\beta$ is a position indicated by arrow F22.

In this example, the listening position $\alpha$ is within the triangle mesh ABC at time $T\alpha$, but the listener moves thereafter, and the listening position $\beta$ is positioned within the triangle mesh BCD at time $T\beta$.

Therefore, in the interpolation processing when the listener is at the listening position $\beta$, the object polar coordinate coded data of the reference viewpoint B to the reference viewpoint D is necessary.

However, the object polar coordinate coded data of the reference viewpoint A to the reference viewpoint C is received at time $T\beta$. Therefore, the client 12 does not have the object polar coordinate coded data of the reference viewpoint D, and cannot correctly perform the interpolation processing for the listening position $\beta$.

As described above, in a case where the listening position $\alpha$ and listening position $\beta$ are positioned in the same triangle mesh, the interpolation processing can be appropriately performed.

On the other hand, it can be seen that, in a case where the listening position $\alpha$ and listening position $\beta$ are positioned in the different triangle meshes due to the influence of transmission delay and the like, the interpolation processing cannot be performed for the current position of the listener. In other words, it can be seen that the rendering processing cannot be continuously performed.

In a case where the received object polar coordinate coded data of the reference viewpoint A to the reference viewpoint C and the listener position information indicating the current listening position $\beta$ are used at time $T\beta$, the interpolation processing and the rendering processing are performed with an incorrect positional relationship (inappropriate positional relationship).

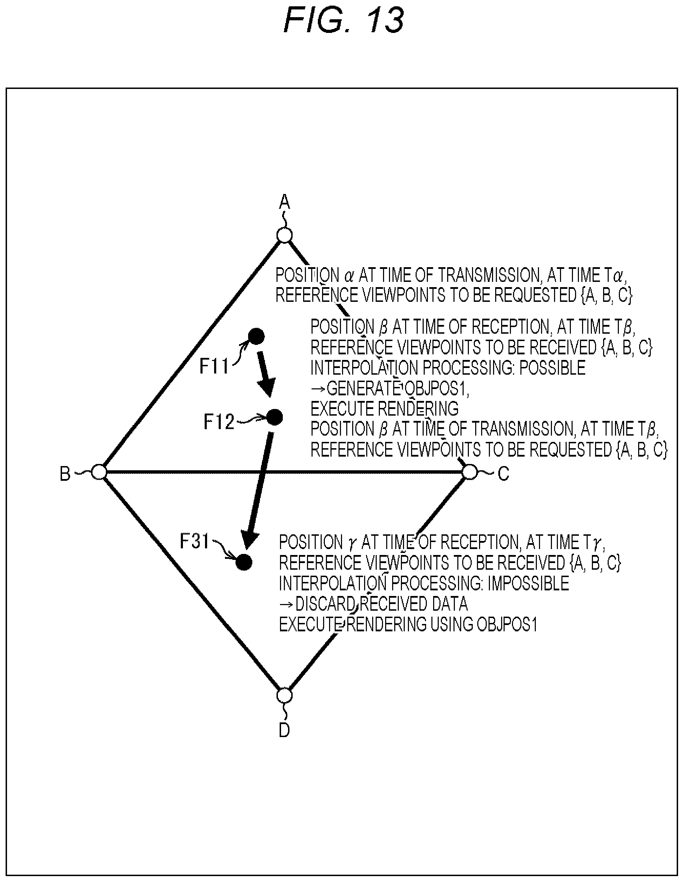

Therefore, in the present technology, for example, as illustrated in Fig. 13, in a case where the listening position $\alpha$ and the listening position $\beta$ are positioned in different triangle meshes, the polar coordinate position information obtained by the last interpolation processing is used as it is, so that the rendering processing can be continuously performed. Note that, in Fig. 13, same reference sign is assigned to a portion corresponding to that in the case of Fig. 11, and description thereof will be omitted as appropriate.

In the example in Fig. 13, the listening position $\alpha$ at time $T\alpha$ is the position indicated by arrow F11, and the listening position $\beta$ at time $T\beta$ is the position indicated by arrow F12. These listening position $\alpha$ and listening position $\beta$ are positioned within the same triangle mesh ABC.

In this case, similar to the example in Fig. 11, at time $T\beta$, the interpolation processing for the listening position $\beta$ is performed using the received object polar coordinate coded data of the reference viewpoint A to the reference viewpoint C.

At this time, it is assumed that object absolute coordinate position information OBJPOS1 is obtained by the interpolation processing. Moreover, at time $T\beta$, polar coordinate transformation is performed on the object absolute coordinate position information OBJPOS1 on the basis of the listening position $\beta$ at time $T\beta$, and the rendering processing is performed on the basis of polar coordinate position information OBJPOS1' obtained as a result.

Furthermore, at time $T\beta$, for the next frame and the like, the viewpoint selection information when the listener is at the listening position $\beta$ is generated, and is transmitted to the server 11. In this example, the viewpoint selection information indicating the reference viewpoint A to the reference viewpoint C is transmitted at time $T\beta$.

Moreover, it is assumed that the object polar coordinate coded data is transmitted from the server 11 in response to the viewpoint selection information transmitted at time $T\beta$, and the object polar coordinate coded data is received by the client 12 at time $T\gamma$.

Furthermore, it is also assumed that the listening position $\gamma$ at time $T\gamma$ is a position indicated by arrow F31.

In this case, the listening position $\gamma$ is positioned within the triangle mesh BCD different from the triangle mesh ABC including the listening position $\beta$.

Therefore, in the interpolation processing for the listening position $\gamma$, the object polar coordinate coded data of the reference viewpoint B to the reference viewpoint D is necessary, but the object polar coordinate coded data of the reference viewpoint D is not received at time $T\gamma$, and thus the interpolation processing cannot be performed.

Therefore, at time $T\gamma$, the received object polar coordinate coded data is discarded, and the rendering processing is performed using the polar coordinate position information OBJPOS1' obtained at immediately preceding time $T\beta$. In other words, at time $T\gamma$, rendering processing is performed using the object absolute coordinate position information OBJPOS1 at immediately preceding time $T\beta$ and the listener position information indicating the listening position $\beta$ as they are.

In this way, at time $T\gamma$, it is possible to avoid the interpolation processing in an inappropriate positional relationship from being performed. That is, it is possible to obtain the reproduction audio data in a state where the object and the listening position have an appropriate positional relationship. Therefore, although some feeling of delay occurs, it is possible to suppress deterioration in quality of the sound of the content.

<Configuration example of content reproduction system>

Here, a more detailed embodiment of the content reproduction system to which the present technology described above is applied will be described.

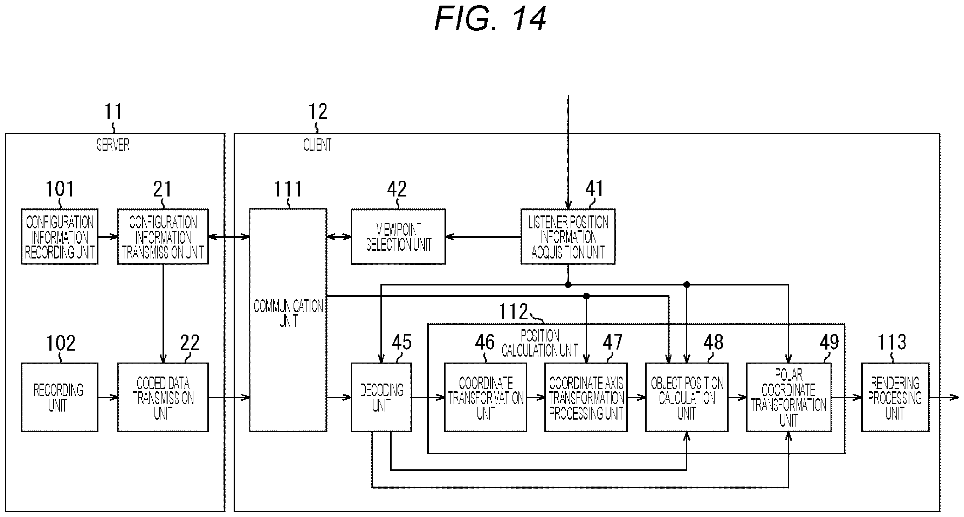

Fig. 14 is a diagram illustrating a configuration example of the content reproduction system to which the present technology is applied. Note that, in Fig. 14, same reference sign is assigned to a portion corresponding to that in the case of Fig. 1, and description thereof will be omitted as appropriate.

The content reproduction system illustrated in Fig. 14 includes the server 11 that distributes content, and the client 12 that receives distribution of the content from the server 11.

Furthermore, the server 11 includes a configuration information recording unit 101, the configuration information transmission unit 21, a recording unit 102, and the coded data transmission unit 22.

The configuration information recording unit 101 records, for example, the system configuration information illustrated in Fig. 2, and supplies the recorded system configuration information to the configuration information transmission unit 21. Note that a part of the recording unit 102 may be the configuration information recording unit 101.

The recording unit 102 records, for example, the coded audio data obtained by coding the audio data of the object constituting the content, the object polar coordinate coded data of each object for each reference viewpoint, the coded gain information, and the like.

The recording unit 102 supplies the coded audio data, the object polar coordinate coded data, the coded gain information, and the like recorded in response to a request and the like, to the coded data transmission unit 22.

Furthermore, the client 12 includes the listener position information acquisition unit 41, the viewpoint selection unit 42, a communication unit 111, the decoding unit 45, a position calculation unit 112, and a rendering processing unit 113.

The communication unit 111 corresponds to the configuration information acquisition unit 43 and the coded data acquisition unit 44 illustrated in Fig. 1, and transmits and receives various kinds of data by communicating with the server 11.

For example, the communication unit 111 transmits the viewpoint selection information supplied from the viewpoint selection unit 42 to the server 11, or receives the system configuration information and the bit stream transmitted from the server 11. That is, the communication unit 111 functions as a reference viewpoint information acquisition unit that acquires the system configuration information, and the object polar coordinate coded data and the coded gain information included in the bit stream, from the server 11.

The position calculation unit 112 generates the polar coordinate position information indicating the position of the object on the basis of the object polar coordinate position information supplied from the decoding unit 45 and the system configuration information supplied from the communication unit 111, and supplies the polar coordinate position information to the rendering processing unit 113.

Furthermore, the position calculation unit 112 performs gain adjustment on the audio data of the object supplied from the decoding unit 45, and supplies the audio data after the gain adjustment to the rendering processing unit 113.

The position calculation unit 112 includes the coordinate transformation unit 46, the coordinate axis transformation processing unit 47, the object position calculation unit 48, and the polar coordinate transformation unit 49.

The rendering processing unit 113 performs the rendering processing such as VBAP on the basis of the polar coordinate position information and the audio data supplied from the polar coordinate transformation unit 49, and generates and outputs the reproduction audio data for reproducing the sound of the content.

<Description of system configuration information transmission processing and system configuration information reception processing>

Next, the operation of the content reproduction system illustrated in Fig. 14 will be described.

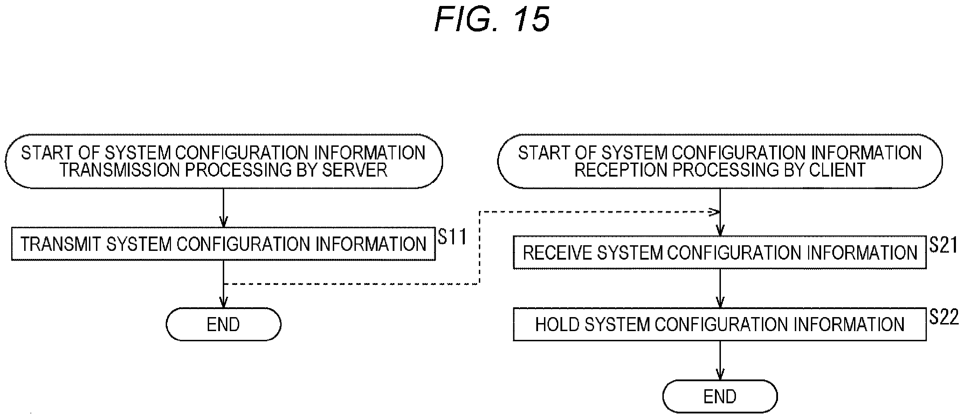

First, the system configuration information transmission processing by the server 11 and the system configuration information reception processing by the client 12 will be described with reference to the flowchart in Fig. 15.

For example, in a case where the connection between the server 11 and the client 12 is established for the distribution of the predetermined content, the system configuration information transmission processing is started, and the processing of step S11 is performed.

That is, in step S11, the configuration information transmission unit 21 reads the system configuration information of the requested content from the configuration information recording unit 101, and transmits the read system configuration information to the client 12, and the system configuration information transmission processing is ended.

For example, the system configuration information is prepared in advance, and is transmitted to the client 12 immediately after the operation of the content reproduction system is started, that is, for example, immediately after the connection between the server 11 and the client 12 is established, and before the coded audio data and the like are transmitted.

Then, in step S21, the communication unit 111 of the client 12 receives the system configuration information transmitted from the server 11, and supplies the system configuration information to the viewpoint selection unit 42, the decoding unit 45, the coordinate axis transformation processing unit 47, and the object position calculation unit 48.

Note that the timing at which the communication unit 111 acquires the system configuration information from the server 11 may be any timing as long as it is before the start of reproduction of the content.

In step S22, the viewpoint selection unit 42, the decoding unit 45, the coordinate axis transformation processing unit 47, and the object position calculation unit 48 hold the system configuration information supplied from the communication unit 111, and the system configuration information reception processing is ended.

As described above, the client 12 acquires and holds the system configuration information before the reproduction of the content, so that the reference viewpoints can be appropriately selected using the system configuration information.

<Description of viewpoint selection information transmission processing>

In a case where the system configuration information reception processing described with reference to Fig. 15 is performed, thereafter, the client 12 continues to perform the viewpoint selection information transmission processing and the reproduction audio data generation processing until the reproduction of the content is ended. Furthermore, in the server 11, after the system configuration information transmission processing, the provision processing is performed.

Hereinafter, the viewpoint selection information transmission processing, the reproduction audio data generation processing, and the provision processing will be described.

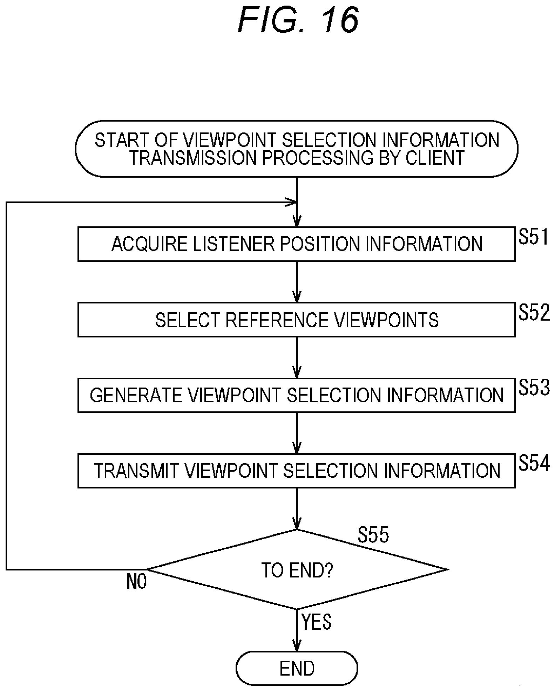

First, the viewpoint selection information transmission processing performed by the client 12 will be described with reference to the flowchart in Fig. 16.

For example, in a case where the viewpoint selection information transmission processing is started, the viewpoint selection unit 42 starts a polling timer for specifying the timing (polling time) for transmitting the viewpoint selection information.

For example, in a case where the object polar coordinate coded data is acquired for each frame of the content (reproduction audio data) to be reproduced, the time as the acquisition timing of the object polar coordinate coded data of the frame to be reproduced next is the polling time. At the polling time, the viewpoint selection unit 42 performs the processing of step S51.

In step S51, the viewpoint selection unit 42 acquires the listener position information from the listener position information acquisition unit 41.

That is, the listener position information acquisition unit 41 acquires the listener position information according to the operation of the listener and the like, and outputs the listener position information to the viewpoint selection unit 42, the decoding unit 45, the object position calculation unit 48, and the polar coordinate transformation unit 49. The viewpoint selection unit 42 acquires the listener position information output from the listener position information acquisition unit 41 in this manner.

In step S52, the viewpoint selection unit 42 selects a plurality of reference viewpoints on the basis of the system configuration information that is supplied from the communication unit 111 and is held, and the listener position information acquired from the listener position information acquisition unit 41.

For example, in a case where three-point interpolation is performed in the object position calculation unit 48, the viewpoint selection unit 42 selects three reference viewpoints surrounding the listening position indicated by the listener position information from among the plurality of reference viewpoints indicated by the system configuration information. In other words, one triangle mesh including the listening position is selected from the plurality of triangle meshes, and three reference viewpoints constituting the triangle mesh are selected.

Furthermore, for example, in a case where two-point interpolation is performed in the object position calculation unit 48, the viewpoint selection unit 42 selects two reference viewpoints sandwiching the listening position from among the plurality of reference viewpoints indicated by the system configuration information. That is, the reference viewpoints are selected such that the listening position is positioned on a line segment connecting the selected two reference viewpoints.

In step S53, the viewpoint selection unit 42 generates the viewpoint selection information indicating the reference viewpoints selected in step S52, and supplies the viewpoint selection information to the communication unit 111. For example, the viewpoint selection information is index information or the like indicating each selected reference viewpoint.

In step S54, the communication unit 111 transmits the viewpoint selection information supplied from the viewpoint selection unit 42 to the server 11. Therefore, transmission of the object polar coordinate coded data at the reference viewpoints indicated by the viewpoint selection information is requested.

In step S55, the client 12 determines whether or not the processing being performed is to be ended. For example, in step S55, it is determined to end the processing in a case where the reproduction end of the content is instructed from the user, a case where a data end signal indicating that the transmission of all the data of the content is ended is received from the server 11, and the like.

In a case where it is decided in step S55 that the processing is not yet to be ended, the processing returns to step S51, and the processing described above is repeatedly performed. In this case, the processing of step S51 is performed at a timing as the next polling time.

On the other hand, in a case where it is determined in step S55 that the processing is to be ended, the client 12 ends the session with the server 11, and stops the processing performed in each unit, and the viewpoint selection information transmission processing is ended.

As described above, the client 12 selects the reference viewpoints according to the listening position, and transmits the viewpoint selection information indicating the selection result to request the transmission of appropriate object polar coordinate coded data. In this way, it is possible to realize content reproduction based on the intention of the content creator according to the listening position.

Moreover, in the content reproduction system, by selecting the reference viewpoints on the client 12 side, the processing load of the server 11 can be reduced as compared with the case where the selection of the reference viewpoints is performed by the server 11. Such a reduction in the processing load of the server 11 is particularly useful in a case where the server 11 simultaneously distributes content to many clients 12.

<Description of provision processing>

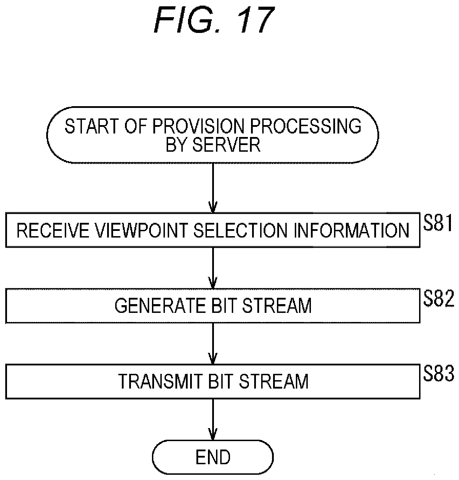

Next, the provision processing performed by the server 11 will be described with reference to the flowchart in Fig. 17. This provision processing is repeatedly performed until the reproduction of the content is ended.

In step S81, the configuration information transmission unit 21 receives the viewpoint selection information transmitted from the client 12, and supplies the viewpoint selection information to the coded data transmission unit 22.

The coded data transmission unit 22 reads the object polar coordinate coded data and the coded gain information of the reference viewpoint indicated by the viewpoint selection information supplied from the configuration information transmission unit 21, from the recording unit 102 for each object, and also reads the coded audio data of each object of the content.

In step S82, the coded data transmission unit 22 multiplexes the object polar coordinate coded data, the coded gain information, and the coded audio data read from the recording unit 102 to generate a bit stream.

In step S83, the coded data transmission unit 22 transmits the generated bit stream to the client 12, and the provision processing is ended. Therefore, the distribution of the content to the client 12 is performed.

As described above, the server 11 generates the bit stream including the object polar coordinate coded data and the coded gain information according to the viewpoint selection information, and transmits the bit stream to the client 12. In this way, it is possible to realize content reproduction based on the intention of the content creator for each client 12.

<Description of reproduction audio data generation processing>

In a case where the provision processing is performed by the server 11 and the bit stream is transmitted, the reproduction audio data generation processing is performed in the client 12.

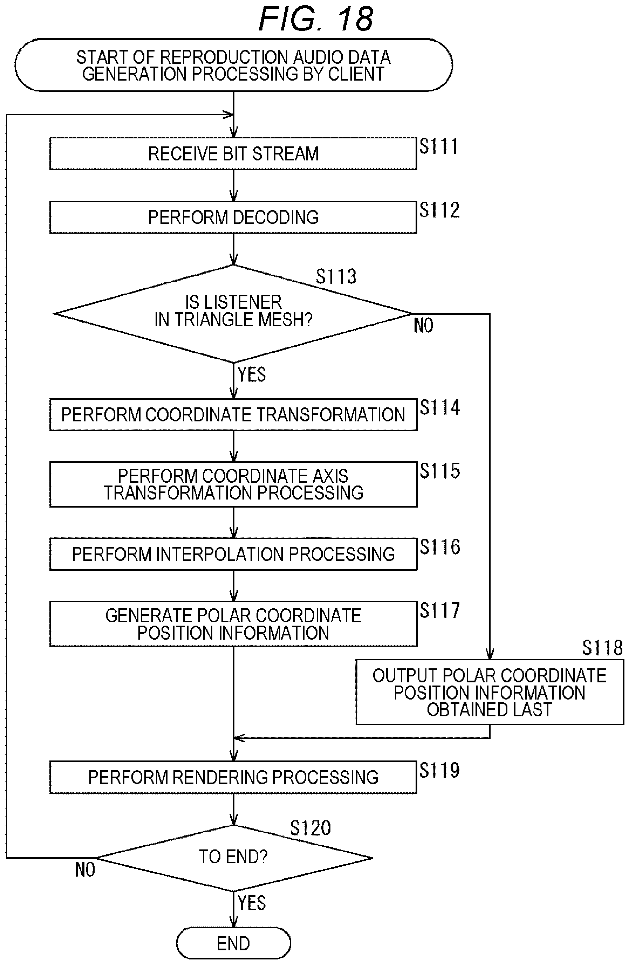

Hereinafter, the reproduction audio data generation processing performed by the client 12 will be described with reference to the flowchart in Fig. 18.

In step S111, the communication unit 111 receives the bit stream transmitted from the server 11, and supplies the bit stream to the decoding unit 45.

In step S112, the decoding unit 45 extracts the object polar coordinate coded data, the coded gain information, and the coded audio data from the bit stream supplied from the communication unit 111, and performs decoding.

In step S113, the decoding unit 45 determines whether or not the listener is in the triangle mesh on the basis of the listener position information, the system configuration information, and the decoding result of the object polar coordinate coded data.

That is, the decoding unit 45 newly acquires the listener position information indicating the position of the listener at the current time, from the listener position information acquisition unit 41, for example, at the timing when the bit stream is received. The current time here is a time later than the time when the viewpoint selection information is transmitted to the server 11 last time.

Furthermore, it is possible to specify which reference viewpoint of the object polar coordinate coded data is included in the bit stream from the result of demultiplexing of the bit stream or decoding of the object polar coordinate coded data.

Note that, hereinafter, the reference viewpoint corresponding to the object polar coordinate coded data included in the received bit stream is also particularly referred to as a reception reference viewpoint. That is, the bit stream includes the object polar coordinate coded data of the reception reference viewpoint.

For example, in a case where three-point interpolation is performed, when the current listening position is included in a triangle mesh (hereinafter, referred to as a reception triangle mesh) including three reception reference viewpoints, the decoding unit 45 determines that the listener is in the triangle mesh.

Therefore, for example, in the state illustrated in Fig. 11, it is determined in step S113 that the listener is in the triangle mesh, and in the state illustrated in Fig. 12, it is determined in step S113 that the listener is not in the triangle mesh.

In a case where it is determined in step S113 that the listener is in the triangle mesh, thereafter, the processing proceeds to step S114.

In this case, the decoding unit 45 supplies the object polar coordinate position information obtained by decoding to the coordinate transformation unit 46, supplies the gain information obtained by decoding to the object position calculation unit 48, and supplies the audio data obtained by decoding to the polar coordinate transformation unit 49.

Note that, in a case where two-point interpolation is performed, when the current listening position is located between the two reception reference viewpoints, the processing proceeds to step S114.

In step S114, the coordinate transformation unit 46 performs coordinate transformation on the object polar coordinate position information of each object supplied from the decoding unit 45, and supplies the object absolute coordinate position information obtained as a result to the coordinate axis transformation processing unit 47.

For example, in step S114, for each reference viewpoint, the above-described Expression (1) is calculated on the basis of the object polar coordinate position information for each object, and the object absolute coordinate position information is calculated.

In step S115, the coordinate axis transformation processing unit 47 performs coordinate axis transformation processing on the object absolute coordinate position information supplied from the coordinate transformation unit 46 on the basis of the system configuration information supplied from the communication unit 111.

The coordinate axis transformation processing unit 47 performs coordinate axis transformation processing for each object for each reference viewpoint, and supplies the object absolute coordinate position information indicating the position of the object in the common absolute coordinate system obtained as a result to the object position calculation unit 48. For example, in step S115, calculation similar to the above-described Expression (3) is performed, and the object absolute coordinate position information is calculated.

In step S116, the object position calculation unit 48 performs interpolation processing on the basis of the system configuration information supplied from the communication unit 111, the listener position information supplied from the listener position information acquisition unit 41, the object absolute coordinate position information supplied from the coordinate axis transformation processing unit 47, and the gain information supplied from the decoding unit 45.

The object position calculation unit 48 newly acquires the listener position information indicating the position of the listener at the current time, from the listener position information acquisition unit 41, for example, at the timing when the bit stream is received.

Then, the object position calculation unit 48 performs the three-point interpolation described above as the interpolation processing for each object, and calculates final object absolute coordinate position information and gain information.

Specifically, the object position calculation unit 48 performs calculation similar to the Expressions (6) to (11) described above on the basis of the reference viewpoint position information included in the system configuration information and the listener position information, and obtains the internal division ratio (m, n) and the internal division ratio (k, 1).

Then, the object position calculation unit 48 performs the interpolation processing of three-point interpolation by performing calculation similar to Expressions (12) to (21) described above on the basis of the obtained internal division ratio (m, n) and internal division ratio (k, l), and the object absolute coordinate position information and gain information of each reference viewpoint.

Furthermore, for example, in a case where two-point interpolation is performed, the object position calculation unit 48 obtains the proportion ratio (m:n) by performing calculation similar to Expression (4) described above on the basis of the reference viewpoint position information included in the system configuration information and the listener position information.

Then, the object position calculation unit 48 performs the interpolation processing of two-point interpolation by performing calculation similar to Expression (5) described above on the basis of the obtained proportion ratio (m:n) and the object absolute coordinate position information and gain information of two reference viewpoints.

Note that, in the two-point interpolation or the three-point interpolation, the interpolation processing may be performed by weighting the object absolute coordinate position information and the gain information of the desired reference viewpoints.

In a case where the interpolation processing is performed in this manner and the final object absolute coordinate position information and gain information are obtained, the object position calculation unit 48 supplies the obtained object absolute coordinate position information and gain information to the polar coordinate transformation unit 49.

In step S117, the polar coordinate transformation unit 49 performs polar coordinate transformation on the object absolute coordinate position information supplied from the object position calculation unit 48 on the basis of the listener position information supplied from the listener position information acquisition unit 41 to generate the polar coordinate position information.

Note that it is assumed that the listener position information used at this time is acquired from the listener position information acquisition unit 41, for example, at the timing when the bit stream is received.

Furthermore, the polar coordinate transformation unit 49 performs gain adjustment on the audio data of each object supplied from the decoding unit 45 on the basis of the gain information of each object supplied from the object position calculation unit 48.

The polar coordinate transformation unit 49 supplies the polar coordinate position information obtained by the polar coordinate transformation and the audio data of each object obtained by the gain adjustment to the rendering processing unit 113, and thereafter, the processing proceeds to step S119.

Furthermore, in a case where it is determined in step S113 that the listener is not in the triangle mesh, the processing proceeds to step S118.

In this case, the listening position at the current time is positioned outside the reception triangle mesh including the reception reference viewpoints surrounding the listening position at the predetermined time which is different from the current time, that is, is selected by the viewpoint selection unit 42 at the predetermined time before the current time.

In a case where it is determined that the listener is not in the triangle mesh, the decoding unit 45 discards the object polar coordinate position information and the gain information obtained by decoding, and supplies the audio data obtained by decoding to the polar coordinate transformation unit 49.

In step S118, the polar coordinate transformation unit 49 supplies (outputs) the polar coordinate position information obtained last, that is, the polar coordinate position information generated in step S117 performed last (immediately before), to the rendering processing unit 113 as it is. That is, the same polar coordinate position information as the previous one is used in the rendering processing in the subsequent stage.

Furthermore, the polar coordinate transformation unit 49 performs gain adjustment on the audio data of each object supplied from the decoding unit 45 on the basis of the gain information of each object, which is generated in step S116 performed last (immediately before) and is supplied from the object position calculation unit 48.

Then, the polar coordinate transformation unit 49 supplies the audio data of each object obtained by the gain adjustment to the rendering processing unit 113, and thereafter, the processing proceeds to step S119. In this case, the gain adjustment of the latest audio data is performed on the basis of the same gain information as that used in the previous gain adjustment.

In a case where the processing of step S117 or step S118 is performed, thereafter, the processing of step S119 is performed.

In step S119, the rendering processing unit 113 performs the rendering processing such as VBAP on the basis of the polar coordinate position information and the audio data of each object supplied from the polar coordinate transformation unit 49, and outputs the reproduction audio data obtained as a result.

For example, in a speaker and the like in the subsequent stage of the rendering processing unit 113, the sound of the content is reproduced on the basis of the reproduction audio data.

In step S120, the client 12 determines whether or not the processing being performed is to be ended. For example, in step S120, it is determined to end the processing in a case where the reproduction end of the content is instructed from the user, a case where a data end signal indicating that the transmission of all the data of the content is ended is received from the server 11, and the like.

In a case where it is decided in step S120 that the processing is not yet to be ended, the processing returns to step S111, and the processing described above is repeatedly performed. In this case, the communication unit 111 is in a standby state for receiving the bit stream, and in a case where a new bit stream is transmitted from the server 11, the processing of step S111 is newly performed.

On the other hand, in a case where it is determined in step S120 that the processing is to be ended, the client 12 ends the session with the server 11, and stops the processing performed in each unit, and the reproduction audio data generation processing is ended.

Note that the rendering processing unit 113 or the polar coordinate transformation unit 49 may perform processing according to the reproduction mode on the audio data of the object on the basis of the listener position information and the information indicating the reproduction mode included in the system configuration information before the rendering processing.

In such a case, for example, attenuation processing such as gain adjustment is performed on the audio data of the object at a position overlapping with the listening position, or the audio data is replaced with zero data and muted. Furthermore, for example, the sound of the audio data of the object at a position overlapping with the listening position is output from all channels (speakers).

As described above, the client 12 performs the interpolation processing on the basis of the information of each reference viewpoint included in the received bit stream, and obtains the object absolute coordinate position information and the gain information of each object.

In this way, it is possible to realize the object arrangement based on the intention of the content creator according to the listening position instead of the simple physical relationship between the listener and the object. Therefore, it is possible to realize the content reproduction based on the intention of the content creator, and to sufficiently deliver the amusement or the realistic feeling of the content to the listener.

Moreover, in a case where the current listening position is not included in the reception triangle mesh, the client 12 can suppress the interpolation processing in an inappropriate positional relationship by using the polar coordinate position information and the gain information that are the same as those used last time as they are. Therefore, the content reproduction with higher quality can be realized.

<Second embodiment>

<Regarding selection of reference viewpoint>

Furthermore, for example, in a case where the content is transmitted in real time by the server 11, not only the reference viewpoint of the triangle mesh including the listening position but also another reference viewpoint may be additionally selected, and the object polar coordinate coded data of those reference viewpoints may be requested.

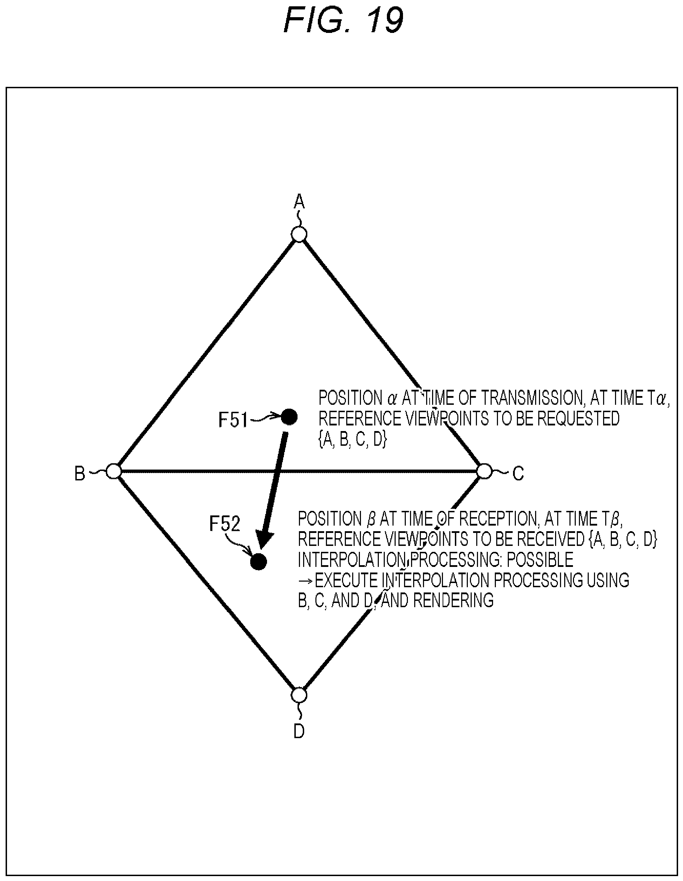

In such a case, for example, selection of the reference viewpoint is performed as illustrated in Fig. 19.

In the example illustrated in Fig. 19, it is assumed that the listening position $\alpha$ at time $T\alpha$ is a position indicated by arrow F51, and the listening position $\beta$ at time $T\beta$ is a position indicated by arrow F52.

In this example, since the listening position $\alpha$ is positioned in the triangle mesh ABC at time $T\alpha$, the reference viewpoint A to the reference viewpoint C are usually selected in the viewpoint selection unit 42.

However, since the listener has moved to the position (listening position $\beta$) in the triangle mesh BCD at time $T\beta$, the object polar coordinate coded data of the reference viewpoint D is newly necessary for performing the interpolation processing.

Therefore, in a case where the listening position $\alpha$ is in the vicinity of the boundary (side) of the triangle mesh ABC including the listening position $\alpha$ at time $T\alpha$, that is, in the vicinity of another triangle mesh adjacent to the triangle mesh ABC, reference viewpoints constituting another triangle mesh adjacent to the triangle mesh ABC may also be additionally selected.

Note that, hereinafter, the additionally selected reference viewpoint is also referred to as an additional reference viewpoint. Furthermore, the triangle mesh selected at the time of generating the viewpoint selection information, that is, the triangle mesh including three selected reference viewpoints which are not the additional reference viewpoint is also referred to as a selected triangle mesh.

Whether or not to select the additional reference viewpoint, that is, whether or not to request the object polar coordinate coded data of the additional reference viewpoint is only required to be determined on the basis of, for example, at least one of a delay time of the transmission and the like, a distance from the listening position to a side of the selected triangle mesh (positional relationship between the selected triangle mesh and the listening position), a moving speed of the listener, or a moving direction of the listener.

Here, the delay time can be, for example, a time from the transmission of the viewpoint selection information to the reception of the bit stream for the frame and the like processed last. Furthermore, the moving speed and the moving direction of the listener can be obtained from the listener position information at each time.

As an example, for example, in a case where a circle having a predetermined radius centered on the listening position $\alpha$ intersects a side of the selected triangle mesh, in other words, in a case where a distance from the listening position $\alpha$ to the side of the selected triangle mesh is equal to or less than a predetermined threshold value, the additional reference viewpoint may be selected. The radius (predetermined threshold value) of the circle at this time may be determined on the basis of, for example, the moving speed and the moving direction of the listener, the delay time, and the like.

Specifically, for example, in the example in Fig. 19, it is assumed that a distance from listening position $\alpha$ indicated by the arrow F51 to a side BC of the selected triangle mesh ABC is equal to or less than the predetermined threshold value.

In this case, the reference viewpoint D of the triangle mesh BCD having the side BC as a side (having the side BC common to the selected triangle mesh ABC) and adjacent to the selected triangle mesh ABC is selected as the additional reference viewpoint.

Then, the viewpoint selection information indicating the additional reference viewpoint D in addition to the reference viewpoint A to the reference viewpoint C is generated.

Then, since the object polar coordinate coded data of the reference viewpoint A to the reference viewpoint D is received at time $T\beta$, even in a case where the listener moves to the triangle mesh BCD, the interpolation processing can be performed on the basis of the received object polar coordinate coded data.

Note that, as another example, a range that can be reached (moved) by the listener until the time when the object polar coordinate coded data will be received next, that is, the estimated value (estimated time) of time $T\beta$ may

be calculated on the basis of, for example, the moving speed and the moving direction of the listener, the delay time, and the like. In such a case, the additional reference viewpoint is only required to be selected in a case where the calculated range (region) intersects the side of the selected triangle mesh.

Furthermore, the number of additional reference viewpoints to be selected may be one or more. For example, the reference viewpoint constituting each of two or more triangle meshes adjacent to the triangle mesh including the current listening position may be selected as the additional reference viewpoint.

As described above, in a case where the additional reference viewpoint is appropriately selected according to the situation, the data transmission amount may increase, but the reproduction audio data in a state in which the object and the listening position have an appropriate positional relationship can be obtained without causing a feeling of delay. Note that the selection of the additional reference viewpoint as described above may be performed on the server 11 side.

<Description of viewpoint selection information transmission processing>

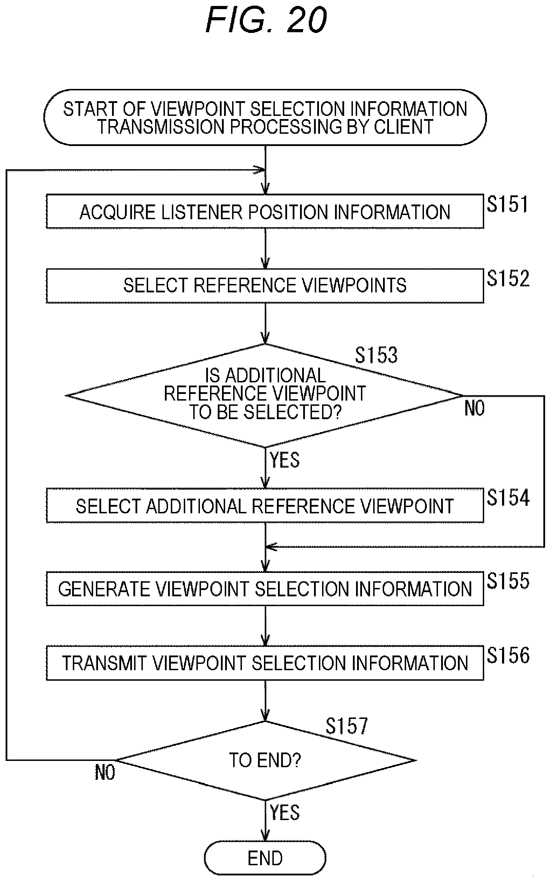

Furthermore, in a case where the selection of the additional reference viewpoint is appropriately performed, the client 12 performs the viewpoint selection information transmission processing illustrated in Fig. 20. Hereinafter, the viewpoint selection information transmission processing performed by the client 12 will be described with reference to the flowchart in Fig. 20.

Note that processing of step S151 and step S152 is similar to the processing of step S51 and step S52 in Fig. 16, and thus the description thereof will be omitted.

In step S153, the viewpoint selection unit 42 determines whether or not an additional reference viewpoint is to be selected on the basis of the selection result of the reference viewpoint in step S152, the delay time of the transmission and the like, and the moving speed and the moving direction of the listener.

For example, as described with reference to Fig. 19, in a case where the distance from the listening position to the side of the selected triangle mesh is equal to or less than the predetermined threshold value and the like, the viewpoint selection unit 42 determines to select an additional reference viewpoint.

In a case where it is determined in step S153 that no additional reference viewpoint is to be selected, processing of step S154 is not performed, and thereafter, the processing proceeds to step S155.

On the other hand, in a case where it is determined in step S153 that an additional reference viewpoint is to be selected, the viewpoint selection unit 42 selects an additional reference viewpoint in step S154.

At this time, the viewpoint selection unit 42 selects an additional reference viewpoint on the basis of at least one of the selection result of the reference viewpoint in step S152 (the positional relationship between the listening position and the selected triangle mesh at the current time), the moving direction and moving speed of the listener, or the delay time of the transmission and the like.

For example, as described with reference to Fig. 19, the viewpoint selection unit 42 selects a reference viewpoint constituting a triangle mesh having a side common to the selected triangle mesh, that is, a triangle mesh adjacent to the selected triangle mesh, as the additional reference viewpoint. Note that two or more reference viewpoints may be selected as the additional reference viewpoint.

In a case where processing of step S154 is performed or it is determined in step S153 that no additional reference viewpoint is to be selected, the viewpoint selection unit 42 generates the viewpoint selection information in step S155, and supplies the viewpoint selection information to the communication unit 111.

For example, in a case where it is determined in step S153 that no additional reference viewpoint is to be selected, the viewpoint selection unit 42 generates the viewpoint selection information indicating the reference viewpoint selected in step S152.

On the other hand, in a case where the processing of step S154 is performed, the viewpoint selection unit 42 generates the viewpoint selection information indicating the reference viewpoint selected in step S152 and the additional reference viewpoint selected in step S154.

In a case where the viewpoint selection information is generated in this manner, thereafter, the processing of step S156 and step S157 is performed, and the viewpoint selection information transmission processing is ended. However, the processing is similar to the processing of step S54 and step S55 in Fig. 16, and thus the description thereof will be omitted.

As described above, the client 12 appropriately selects the additional reference viewpoint, and generates the viewpoint selection information. In this way, even in a case where the listener has moved, it is possible to suppress that the positional relationship between the listening position at the time of receiving the bit stream and the reception reference viewpoint becomes inappropriate and the interpolation processing and the like cannot be performed.

<Description of reproduction audio data generation processing>

Furthermore, in a case where the viewpoint selection information transmission processing described with reference to Fig. 20 is performed, the provision processing described with reference to Fig. 17 is performed in the server 11.

In this case, in step S82, a bit stream that includes not only the reference viewpoint of the triangle mesh including the listening position but also the object polar coordinate coded data and the coded gain information for the additional reference viewpoint as appropriate is generated according to the viewpoint selection information.

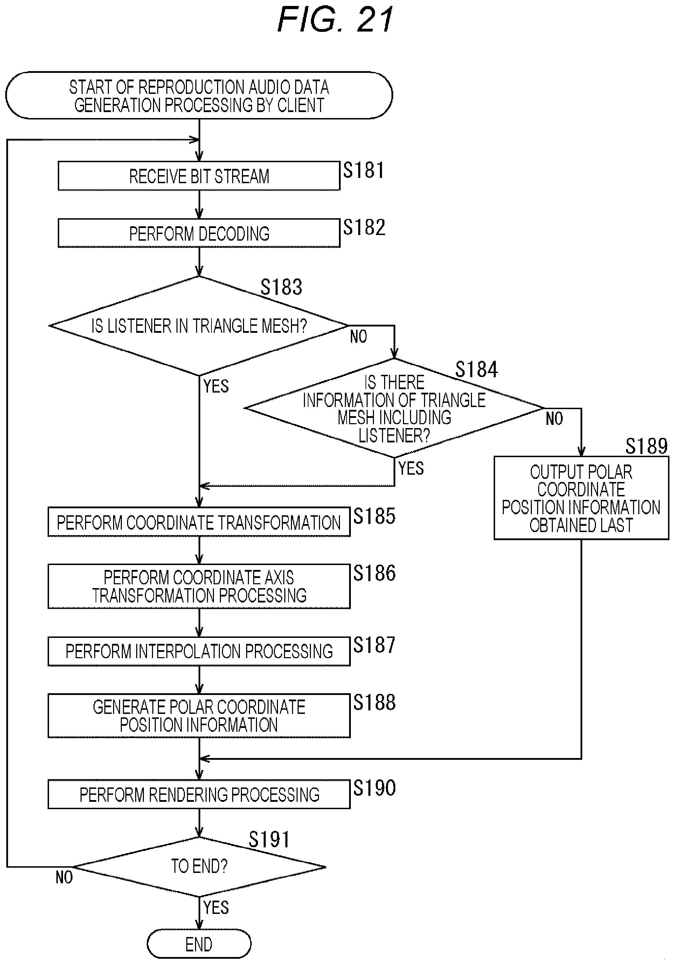

Furthermore, in a case where such a bit stream is transmitted, the client 12 performs the reproduction audio data generation processing illustrated in Fig. 21.

Hereinafter, the reproduction audio data generation processing performed by the client 12 will be described with reference to the flowchart in Fig. 21. Note that, since processing of step S181 to step S183 is similar to the processing of step S111 to step S113 in Fig. 18, the description thereof is appropriately omitted.

Here, in step S183, in a case where the current listening position is included in the triangle mesh formed by the three reference viewpoints that are not the additional reference viewpoint, that is, the three reference viewpoints selected in step S152 in Fig. 20 among the reference viewpoints indicated by the viewpoint selection information, it is determined that the listener is in the triangle mesh.

In a case where it is determined in step S183 that the listener is in the triangle mesh, thereafter, processing of step S185 to step S188 is performed, and the processing proceeds to step S190. Note that the processing of step S185 to step S188 is similar to the processing of step S114 to step S117 in Fig. 18, and thus the description thereof will be omitted.

Furthermore, in a case where it is determined in step S183 that the listener is not in the triangle mesh, in step S184, the decoding unit 45 determines whether or not there is information of the triangle mesh including the listening position at the time (current time) when the bit stream is received.

Here, in a case where there is an additional reference viewpoint in the reception reference viewpoints, and the current listening position is included in the triangle mesh formed by the three reception reference viewpoints including the additional reference viewpoint, it is determined that there is the information of the triangle mesh.

In a case where it is determined in step S184 that there is the information of the triangle mesh including the listening position, thereafter, the processing of step S185 to step S188 is performed, and the processing proceeds to step S190.

In this case, the processing of step S185 to step S188 is performed using the object polar coordinate position information and the gain information of the three reception reference viewpoints including the additional reference viewpoint, which form the triangle mesh including the current listening position.

Moreover, in a case where it is determined in step S184 that there is no information of the triangle mesh including the listening position, the processing proceeds to step S189.

In step S189, the processing similar to the processing of step S118 in Fig. 18 is performed, and the processing proceeds to step S190. That is, the polar coordinate position information generated last is supplied as it is to the rendering processing unit 113.

In a case where the processing of step S188 or step S189 is performed, thereafter, the processing of step S190 and step S191 is performed, and the reproduction audio data generation processing is ended. However, the processing is similar to the processing of step S119 and step S120 in Fig. 18, and the description thereof is omitted.

As described above, the client 12 performs the interpolation processing also using the object polar coordinate position information and the gain information of the additional reference viewpoint as necessary. In this way, even in a case where the listener has moved, it is possible to suppress that the interpolation processing and the like cannot be performed.

<Third embodiment>

<Regarding selection of reference viewpoint>

Meanwhile, the content distributed by the server 11 may be archive content in which the object polar coordinate coded data and the coded audio data are produced in advance before the contribution of the content for all reproduction times (frames). In such a case, the server 11 can extract and transmit data of an arbitrary reproduction time.

Therefore, in consideration of the delay time such as a network delay, data at the reproduction time matched with an assumed reception time in the client 12 may be transmitted. As a result, the object polar coordinate position information and the gain information at the time close to the actual reproduction time in the client 12 can be transmitted to the client 12.

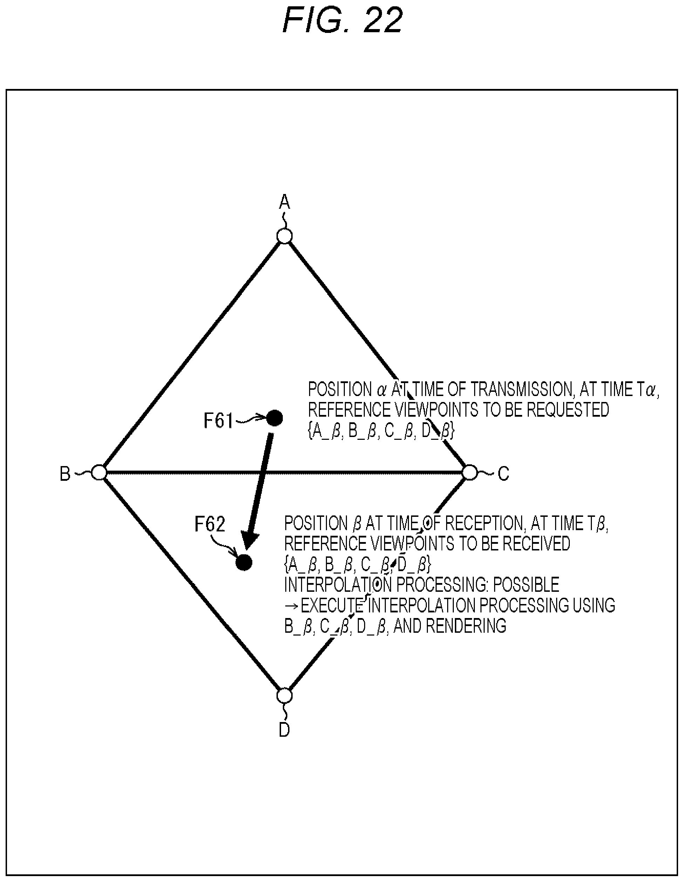

Specifically, for example, as illustrated in Fig. 22, it is assumed that the listening position $\alpha$ at time $T\alpha$ is a position indicated by arrow F61, and the listening position $\beta$ at time $T\beta$ is a position indicated by arrow F62.

In this example, since the listening position $\alpha$ is positioned in the triangle mesh ABC at time $T\alpha$, the reference viewpoint A to the reference viewpoint C are selected in the viewpoint selection unit 42.

Furthermore, in the viewpoint selection unit 42, for example, a delay time of transmission and the like is obtained from a measurement result of the time from the transmission of the viewpoint selection information in the last processed frame and the like to the reception of the bit stream, and time Tβ that is data reception time is estimated on the basis of the delay time.

Moreover, in the viewpoint selection unit 42, estimated time Tβ is considered, and for example, similar to the case in Fig. 19, in a case where the listening position α is in the vicinity of the boundary (side) of the triangle mesh ABC including the listening position α, an additional reference viewpoint is also selected. In this example, the reference viewpoint D is selected as the additional reference viewpoint.

Then, the viewpoint selection unit 42 generates viewpoint selection information indicating selected reference viewpoint A to reference viewpoint D including request time information indicating estimated time Tβ, more specifically, the reproduction time (frame) such as a presentation timestamp corresponding to time Tβ.

Then, the coded audio data corresponding to time Tα and the object polar coordinate coded data and the coded gain information of the reference viewpoint A to the reference viewpoint D corresponding to time Tβ indicated by the request time information are transmitted from the server 11. The coded audio data corresponding to time Tα here is the coded audio data at the reproduction time next to the coded audio data at the predetermined reproduction time transmitted last by the server 11.

By generating such viewpoint selection information, the client 12 can obtain the object polar coordinate coded data and the coded gain information at time Tβ of the reference viewpoint B to the reference viewpoint D constituting the triangle mesh BCD including the listening position β.

Therefore, at actual time Tβ, the interpolation processing and the rendering processing are performed similarly to the case in the example in Fig. 19, and the reproduction audio data in which the object and the listening position are in an appropriate positional relationship can be obtained without causing a feeling of delay.

<Description of viewpoint selection information transmission processing>

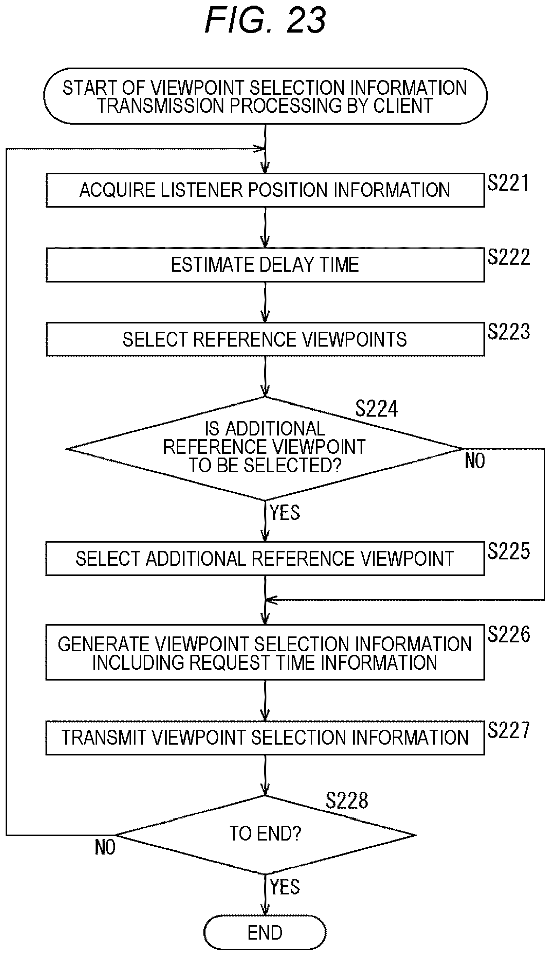

Furthermore, in a case where the viewpoint selection information is generated as illustrated in Fig. 22, the client 12 performs the viewpoint selection information transmission processing illustrated in Fig. 23. Hereinafter, the viewpoint selection information transmission processing performed by the client 12 will be described with reference to the flowchart in Fig. 23.

In a case where the viewpoint selection information transmission processing is started, the listener position information is acquired in step S221, and the delay time (transmission delay) is estimated in step S222. Note that the processing of step S221 is similar to the processing of step S151 in Fig. 20, and thus the description thereof will be omitted.

In step S222, the viewpoint selection unit 42 estimates the delay time from the current time until the next bit stream is received from the server 11.

Specifically, for example, the measurement result of the time from the last execution of the processing in step S227 to the reception of the bit stream (until step S181 in Fig. 21 is performed last) is set as the delay time and the like. Furthermore, the viewpoint selection unit 42 also estimates the estimated reception time (assumed acquisition time) of the next bit stream from the estimated delay time.

In a case where the delay time is estimated, thereafter, the processing of step S223 to step S225 is performed, but the processing is similar to the processing of step S152 to step S154 in Fig. 20, and thus the description thereof will be omitted. Note that, in step S223 to step S225, the processing may be performed in consideration of the delay time estimated in step S222.

In step S226, the viewpoint selection unit 42 generates the viewpoint selection information including the request time information indicating the reproduction time corresponding to the estimated reception time of the bit stream, and supplies the viewpoint selection information to the communication unit 111. Therefore, transmission of the object polar coordinate coded data and the coded gain information at the reproduction time corresponding to the estimated reception time is requested.

In this case, for example, in a case where the processing of step S225 is not performed, the viewpoint selection information indicating the reference viewpoint selected in step S223 is generated.

On the other hand, in a case where the processing of step S225 is performed, the viewpoint selection information indicating the reference viewpoints selected in step S223 and the additional reference viewpoint selected in step S225 is generated.

In a case where the viewpoint selection information is generated, thereafter, the processing of step S227 and step S228 is performed, and the viewpoint selection information transmission processing is ended. However, the processing is similar to the processing of step S156 and step S157 in Fig. 20, and thus the description thereof will be omitted.

As described above, the client 12 generates the viewpoint selection information including the request time information. In this way, the client 12 can obtain the object polar coordinate coded data and the coded gain information of the object at the reproduction time corresponding to the reception time of the bit stream. Therefore, it is possible to obtain the reproduction audio data in a state where the object and the listening position have an appropriate positional relationship without causing a feeling of delay.

Note that, also in this embodiment, the provision processing described with reference to Fig. 17 is performed in the server 11.

However, in this case, in step S83, the coded audio data at the reproduction time next to the coded audio data at the reproduction time transmitted in step S83 performed last (immediately before) is stored in the bit stream. Furthermore, in the bit stream, the object polar coordinate coded data and the coded gain information at the reproduction time indicated by the request time information are stored.

Moreover, in this embodiment, in a case where the bit stream is transmitted from the server 11, the reproduction audio data generation processing described with reference to Fig. 21 is performed in the client 12. In this case, in step S185 to step S188, the interpolation processing is performed on the basis of the object polar coordinate position information and the gain information at the reproduction time indicated by the request time information.

<Configuration example of computer>

Note that, the above-described series of processing may be executed by hardware or by software. In a case where a series of processing is executed by the software, a program constituting the software is installed on a computer. Here, examples of the computer include a computer incorporated in dedicated hardware, and for example, a general-purpose personal computer capable of executing various functions by installing various programs.

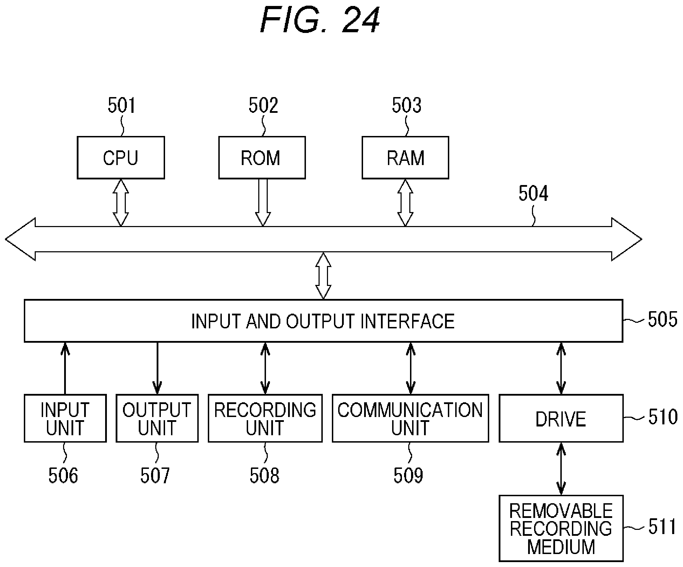

Fig. 24 is a block diagram illustrating a configuration example of hardware of a computer that executes the above-described series of processing by a program.

In the computer, a central processing unit (CPU) 501, a read only memory (ROM) 502, and a random access memory (RAM) 503 are mutually connected by a bus 504.

Moreover, an input and output interface 505 is connected to the bus 504. An input unit 506, an output unit 507, a recording unit 508, a communication unit 509, and a drive 510 are connected to the input and output interface 505.

The input unit 506 includes a keyboard, a mouse, a microphone, an imaging element, and the like. The output unit 507 includes a display, a speaker, and the like. The recording unit 508 includes a hard disk, a nonvolatile memory, and the like. The communication unit 509 includes a network interface and the like. The drive 510 drives a removable recording medium 511 such as a magnetic disk, an optical disk, a magneto-optical disk, or a semiconductor memory.

In the computer configured as described above, the CPU 501 loads, for example, a program recorded in the recording unit 508 into the RAM 503 via the input and output interface 505 and the bus 504, and executes the program, so as to perform the above-described series of processing.

The program executed by the computer (CPU 501) can be provided by being recorded on the removable recording medium 511 as a package medium and the like, for example. Furthermore, the program can be provided via a wired or wireless transmission medium such as a local area network, the Internet, or digital satellite broadcasting.

In the computer, the program can be installed in the recording unit 508 via the input and output interface 505 by mounting the removable recording medium 511 to the drive 510. Furthermore, the program can be received by the communication unit 509 via the wired or wireless transmission medium to be installed on the recording unit 508. In addition, the program can be installed in the ROM 502 or the recording unit 508 in advance.

Note that the program executed by the computer may be a program for processing in time series in the order described in the present description, or a program for processing in parallel or at a necessary timing such as when a call is made.

Furthermore, the embodiments of the present technology are not limited to the above-described embodiments, and various modifications are possible without departing from the scope of the present technology.

For example, the present technology may be configured as cloud computing in which one function is shared by a plurality of devices via the network to process together.

Furthermore, each step described in the above-described flowchart can be executed by one device or executed by a plurality of devices in a shared manner.

Moreover, in a case where a plurality of kinds of processing is included in one step, the plurality of kinds of processing included in one step can be executed by one device or by a plurality of devices in a shared manner.

Moreover, the present technology can also have the following configuration.

(1) An information processing device including:

a listener position information acquisition unit that acquires listener position information indicating a listening position;
a viewpoint selection unit that selects, from among a plurality of reference viewpoints, a plurality of the reference viewpoints forming a region including the listening position at a predetermined time;
a reference viewpoint information acquisition unit that acquires viewpoint position information of the plurality of the reference viewpoints, and object position information of an object of the reference viewpoint for each of the plurality of the reference viewpoints; and

an object position calculation unit that

in a case where, at a time different from the predetermined time, the listening position is out of the region including the listening position at the predetermined time,

calculates position information of the object of the listening position on the basis of the object position information of the plurality of the reference viewpoints forming the region including the listening position at the different time, or outputs the position information of the object of the listening position obtained last.

(2) The information processing device described in (1),
in which the reference viewpoint is a viewpoint set in advance by a content creator.
(3) The information processing device described in (1) or (2), further including:
a rendering processing unit that performs rendering processing on the basis of the position information of the object of the listening position, and audio data of the object.
(4) The information processing device described in (3),

in which the reference viewpoint information acquisition unit further acquires gain information of the object of the reference viewpoint for each of the plurality of the reference viewpoints,
the object position calculation unit

in a case where, at the different time, the listening position is out of the region including the listening position at the predetermined time,

calculates the gain information of the listening position on the basis of the gain information of the plurality of the reference viewpoints forming the region including the listening position at the different time, and performs gain adjustment of the audio data on the basis of the calculated gain information, or

performs gain adjustment of the audio data on the basis of the gain information of the listening position obtained last.

(5) The information processing device described in any one of (1) to (4),

in which the reference viewpoint information acquisition unit acquires the object position information of the plurality of the reference viewpoints forming the region including the listening position at the predetermined time, and

the object position calculation unit, in a case where, at the different times, the listening position is out of the region including the listening position at the predetermined time, outputs the position information of the object of the listening position obtained last.

(6) The information processing device described in any one of (1) to (4),

in which the viewpoint selection unit selects the plurality of the reference viewpoints forming the region including the listening position at the predetermined time, and the reference viewpoint forming another region adjacent to the region,

the reference viewpoint information acquisition unit acquires the object position information of the plurality of the reference viewpoints selected by the viewpoint selection unit, and

the object position calculation unit, in a case where, at the different time, the listening position is in the other region, calculates the position information of the object of the listening position on the basis of the object position information of the plurality of the reference viewpoints forming the other region.

(7) The information processing device described in (6),
in which the viewpoint selection unit selects the reference viewpoint forming the other region on the basis of at least one of a positional relationship between the region and the listening position at the predetermined time, a moving direction and a moving speed of a listener, or a delay time until the object position information is acquired.
(8) The information processing device described in (7), in which the viewpoint selection unit estimates an assumed acquisition time of the object position information on the basis of the delay time, and
the reference viewpoint information acquisition unit acquires the object position information at a reproduction time corresponding to the assumed acquisition time of the plurality of the reference viewpoints selected by the viewpoint selection unit.
(9) The information processing device described in any one of (1) to (8),
in which the object position calculation unit calculates the position information of the object of the listening position by interpolation processing on the basis of the listener position information, the viewpoint position information of the plurality of the reference viewpoints, and the object position information of the plurality of the reference viewpoints.

(10) The information processing device described in (9),

in which the object position calculation unit performs the interpolation processing by weighting the object position information of the plurality of the reference viewpoints.

(11) The information processing device described in (9) or (10),

in which the object position calculation unit performs the interpolation processing on the basis of the viewpoint position information of the two reference viewpoints sandwiching the listening position, and the object position information.

(12) The information processing device described in (9) or (10),

in which the object position calculation unit performs the interpolation processing on the basis of the viewpoint position information of the three reference viewpoints surrounding the listening position, and the object position information.

(13) The information processing device described in (4),

in which the object position calculation unit calculates the gain information of the listening position by interpolation processing on the basis of the listener position information, the viewpoint position information of the plurality of the reference viewpoints, and the gain information of the plurality of the reference viewpoints.

(14) The information processing device described in any one of (1) to (13),

in which the object position calculation unit calculates the position information of the object of the listening position by interpolation processing on the basis of the listener position information, the viewpoint position information of the plurality of the reference viewpoints, the object position information of the plurality of the reference viewpoints, and listener orientation information indicating a face orientation of a listener of the reference viewpoint, set for each of the plurality of the reference viewpoints.

(15) The information processing device described in (14),

in which the reference viewpoint information acquisition unit acquires configuration information including the viewpoint position information and the listener orientation information of each of the plurality of the reference viewpoints.

(16) The information processing device described in (15),

in which the configuration information includes information indicating a number of the plurality of the reference viewpoints, and information indicating a number of the objects.

(17) An information processing method of an information processing device, the information processing method including:

acquiring listener position information indicating a listening position;

selecting, from among a plurality of reference viewpoints, a plurality of the reference viewpoints forming a region including the listening position at a predetermined time;

acquiring viewpoint position information of the plurality of the reference viewpoints, and object position information of an object of the reference viewpoint for each of the plurality of the reference viewpoints; and

in a case where, at a time different from the predetermined time, the listening position is out of the region including the listening position at the predetermined time,

calculating position information of the object of the listening position on the basis of the object position information of the plurality of the reference viewpoints forming the region including the listening position at the different time, or outputting the position information of the object of the listening position obtained last.

(18) A program causing a computer to execute processing of:

acquiring listener position information indicating a listening position;

selecting, from among a plurality of reference viewpoints, a plurality of the reference viewpoints forming a region including the listening position at a predetermined time;

acquiring viewpoint position information of the plurality of reference viewpoints, and object position information of an object of the reference viewpoint for each of the plurality of reference viewpoints; and

in a case where, at a time different from the predetermined time, the listening position is out of the region including the listening position at the predetermined time,

calculating position information of the object of the listening position on the basis of the object position information of the plurality of reference viewpoints forming the region including the listening position at the different time, or outputting the position information of the object of the listening position obtained last.

REFERENCE SIGNS LIST

| | |
|---|---|
| 11 | Server |
| 12 | Client |
| 41 | listener position information acquisition unit |
| 42 | Viewpoint selection unit |
| 45 | Decoding unit |
| 111 | Communication unit |
| 112 | Position calculation unit |
| 113 | Rendering processing unit |

**Claims**

1. An information processing device comprising:

   a listener position information acquisition unit that acquires listener position information indicating a listening position;
   a viewpoint selection unit that selects, from among a plurality of reference viewpoints, a plurality of the reference viewpoints forming a region including the listening position at a predetermined time;
   a reference viewpoint information acquisition unit that acquires viewpoint position information of the plurality of the reference viewpoints, and object position information of an object of the reference viewpoint for each of the plurality of the reference viewpoints; and
   an object position calculation unit that
   in a case where, at a time different from the predetermined time, the listening position is out of the region including the listening position at the predetermined time,
   calculates position information of the object of the listening position on a basis of the object position information of the plurality of the reference viewpoints forming the region including the listening position at the different time, or
   outputs the position information of the object of the listening position obtained last.

2. The information processing device according to claim 1,
   wherein the reference viewpoint is a viewpoint set in advance by a content creator.

3. The information processing device according to claim 1, further comprising:
   a rendering processing unit that performs rendering processing on a basis of the position information of the object of the listening position, and audio data of the object.

4. The information processing device according to claim 3,

   wherein the reference viewpoint information acquisition unit further acquires gain information of the object of the reference viewpoint for each of the plurality of the reference viewpoints,
   the object position calculation unit
   in a case where, at the different time, the listening position is out of the region including the listening position at the predetermined time,
   calculates the gain information of the listening position on a basis of the gain information of the plurality of the reference viewpoints forming the region including the listening position at the different time, and performs gain adjustment of the audio data on a basis of the calculated gain information, or
   performs gain adjustment of the audio data on a basis of the gain information of the listening position obtained last.

5. The information processing device according to claim 1,

   wherein the reference viewpoint information acquisition unit acquires the object position information of the plurality of the reference viewpoints forming the region including the listening position at the predetermined time, and
   the object position calculation unit, in a case where, at the different times, the listening position is out of the region including the listening position at the predetermined time, outputs the position information of the object of the listening position obtained last.

6. The information processing device according to claim 1,

   wherein the viewpoint selection unit selects the plurality of the reference viewpoints forming the region including the listening position at the predetermined time, and the reference viewpoint forming another region adjacent to the region,
   the reference viewpoint information acquisition unit acquires the object position information of the plurality of the reference viewpoints selected by the viewpoint selection unit, and
   the object position calculation unit, in a case where, at the different time, the listening position is in the other region, calculates the position information of the object of the listening position on a basis of the object position information of the plurality of the reference viewpoints forming the other region.

7. The information processing device according to claim 6,
   wherein the viewpoint selection unit selects the reference viewpoint forming the other region on a basis of at least one of a positional relationship between the region and the listening position at the predetermined time, a moving direction and a moving speed of a listener, or a delay time until the object position information is acquired.

8. The information processing device according to claim 7,

   wherein the viewpoint selection unit estimates an assumed acquisition time of the object position information on a basis of the delay time, and
   the reference viewpoint information acquisition unit acquires the object position information at a reproduction time corresponding to the assumed acquisition time of the plurality of the reference viewpoints selected by the viewpoint selection unit.

9. The information processing device according to claim 1,
   wherein the object position calculation unit calculates the position information of the object of the listening position by interpolation processing on a basis of the listener position information, the viewpoint position information of the plurality of the reference viewpoints, and the object position information of the plurality of the reference viewpoints.

10. The information processing device according to claim 9,
    wherein the object position calculation unit performs the interpolation processing by weighting the object position information of the plurality of the reference viewpoints.

11. The information processing device according to claim 9,
    wherein the object position calculation unit performs the interpolation processing on a basis of the viewpoint position information of the two reference viewpoints sandwiching the listening position, and the object position information.

12. The information processing device according to claim 9,
    wherein the object position calculation unit performs the interpolation processing on a basis of the viewpoint position information of the three reference viewpoints surrounding the listening position, and the object position information.

13. The information processing device according to claim 4,
    wherein the object position calculation unit calculates the gain information of the listening position by interpolation processing on a basis of the listener position information, the viewpoint position information of the plurality of the reference viewpoints, and the gain information of the plurality of the reference viewpoints.

14. The information processing device according to claim 1,
    wherein the object position calculation unit calculates the position information of the object of the listening position by interpolation processing on a basis of the listener position information, the viewpoint position information of the plurality of the reference viewpoints, the object position information of the plurality of the reference viewpoints, and listener orientation information indicating a face orientation of a listener of the reference viewpoint, set for each of the plurality of the reference viewpoints.

15. The information processing device according to claim 14,
    wherein the reference viewpoint information acquisition unit acquires configuration information including the viewpoint position information and the listener orientation information of each of the plurality of the reference viewpoints.

**16.** The information processing device according to claim 15,
wherein the configuration information includes information indicating a number of the plurality of the reference viewpoints, and information indicating a number of the objects.

**17.** An information processing method of an information processing device, the information processing method comprising:

acquiring listener position information indicating a listening position;
selecting, from among a plurality of reference viewpoints, a plurality of the reference viewpoints forming a region including the listening position at a predetermined time;
acquiring viewpoint position information of the plurality of the reference viewpoints, and object position information of an object of the reference viewpoint for each of the plurality of the reference viewpoints; and
in a case where, at a time different from the predetermined time, the listening position is out of the region including the listening position at the predetermined time,
calculating position information of the object of the listening position on a basis of the object position information of the plurality of the reference viewpoints forming the region including the listening position at the different time, or outputting the position information of the object of the listening position obtained last.

**18.** A program causing a computer to execute processing of:

acquiring listener position information indicating a listening position;
selecting, from among a plurality of reference viewpoints, a plurality of the reference viewpoints forming a region including the listening position at a predetermined time;
acquiring viewpoint position information of the plurality of the reference viewpoints, and object position information of an object of the reference viewpoint for each of the plurality of the reference viewpoints; and
in a case where, at a time different from the predetermined time, the listening position is out of the region including the listening position at the predetermined time,
calculating position information of the object of the listening position on a basis of the object position information of the plurality of the reference viewpoints forming the region including the listening position at the different time, or outputting the position information of the object of the listening position obtained last.

## FIG. 1

## FIG. 2

| syntax | |
|---|---|
| fva_structure_info_polar () { | |
| **NumOfObjs**; | NUMBER OF OBJECTS |
| **NumfOfRefViewPoint**; | NUMBER OF REFERENCE VIEWPOINTS |
| for (i = 0; i < NumfOfRefViewPoint; i++) { | |
| **RefViewX[i]**; | ASSUMED ABSOLUTE COORDINATE POSITION (X AXIS) OF REFERENCE VIEWPOINT |
| **RefViewY[i]**; | ASSUMED ABSOLUTE COORDINATE POSITION (Y AXIS) OF REFERENCE VIEWPOINT |
| **RefViewZ[i]**; | ASSUMED ABSOLUTE COORDINATE POSITION (Z AXIS) OF REFERENCE VIEWPOINT |
| **ListenerYaw[i]**; | FACE ORIENTATION (YAW DIRECTION) OF LISTENER ASSUMED TO BE AT EACH REFERENCE VIEWPOINT POSITION |
| **ListenerPitch[i]**; | FACE ORIENTATION (PITCH DIRECTION) OF LISTENER ASSUMED TO BE AT EACH REFERENCE VIEWPOINT POSITION |
| } | |
| for (i = 0; i < NumOfObjs; i++) { | |
| **ObjectOverLapMode[i]**; | REPRODUCTION MODE IN CASE WHERE LISTENER AND OBJECT OVERLAP EACH OTHER |
| } | |
| } | |

## FIG. 3

$$x = -r*\sin\theta*\cos\gamma$$

$$y = r*\cos\theta*\cos\gamma$$

$$z = r*\sin\gamma$$

# FIG. 4

*FIG. 5*

## FIG. 6

VIEWPOINT SIDE

A $(x_a, y_a)$

$(x_f, y_f)$ F

B $(x_b, y_b)$

C $(x_c, y_c)$

OBJECT SIDE

A' $(x_a', y_a')$

F' $(x_f', y_f')$

B' $(x_b', y_b')$

C' $(x_c', y_c')$

# FIG. 7

# FIG. 8

## FIG. 9

OBJECT SIDE

A′ $(x_a', y_a', z_a')$、 GAIN $G_a'$ [dB]

E′ $(x_e', y_e', z_e')$

$(x_d', y_d', z_d')$、 GAIN $G_d'$ [dB]

m

D′  o

p

n

B′ $(x_b', y_b', z_b')$、 GAIN $G_b'$ [dB]

C′ $(x_c', y_c', z_c')$、 GAIN $G_c'$ [dB]

F′ $(x_f', y_f', z_f')$、 GAIN $G_f'$ [dB]

# FIG. 10

SERVER        CLIENT        SERVER        CLIENT

GENERATION OF OBJECT POLAR COORDINATE CODED DATA OF ALL REFERENCE VIEWPOINTS

GENERATION OF SYSTEM CONFIGURATION INFORMATION

TRANSMISSION OF SYSTEM CONFIGURATION INFORMATION

DECODING OF SYSTEM CONFIGURATION INFORMATION AND INITIALIZATION OF CLIENT SYSTEM

Q41

SELECTION OF REFERENCE VIEWPOINT ACCORDING TO LISTENER POSITION

VIEWPOINT SELECTION INFORMATION

TIME $T\alpha$, POSITION $\alpha$ OF LISTENER

TRANSMISSION PREPARATION OF OBJECT POLAR COORDINATE CODED DATA OF REQUESTED REFERENCE VIEWPOINT

DELAY TIME OF NETWORK

TRANSMISSION OF BIT STREAM

Q42

TIME $T\beta$, POSITION $\beta$ OF LISTENER

TRANSFORMATION INTO OBJECT ABSOLUTE COORDINATE POSITION INFORMATION

DEVELOPMENT INTO COMMON ABSOLUTE COORDINATE SPACE

CALCULATE INTERNAL DIVISION RATIO

INTERPOLATION PROCESSING

EXECUTION OF RENDERING PROCESSING

POLAR COORDINATE TRANSFORMATION

RENDERING PROCESSING ON ALL OBJECTS

VIEWPOINT SELECTION INFORMATION

EP 4 336 862 A1

## FIG. 11

POSITION $\alpha$ AT TIME OF TRANSMISSION,
AT TIME T$\alpha$,
REFERENCE VIEWPOINTS TO BE REQUESTED
{A, B, C}

F11

POSITION $\beta$ AT TIME OF RECEPTION, AT TIME T$\beta$,
REFERENCE VIEWPOINTS TO BE RECEIVED {A, B, C}
INTERPOLATION PROCESSING: POSSIBLE

F12

A

B

C

D

# FIG. 12

A

POSITION $\alpha$ AT TIME OF TRANSMISSION, AT TIME T$\alpha$,
REFERENCE VIEWPOINTS TO BE REQUESTED {A, B, C}

●←F21

B          C

●←F22

POSITION $\beta$ AT TIME OF RECEPTION,
AT TIME T$\beta$,
REFERENCE VIEWPOINTS TO BE RECEIVED
{A, B, C}
INTERPOLATION PROCESSING: IMPOSSIBLE

D

# FIG. 13

A

POSITION $\alpha$ AT TIME OF TRANSMISSION, AT TIME T$\alpha$,
REFERENCE VIEWPOINTS TO BE REQUESTED {A, B, C}

POSITION $\beta$ AT TIME OF RECEPTION, AT TIME T$\beta$,
REFERENCE VIEWPOINTS TO BE RECEIVED {A, B, C}
INTERPOLATION PROCESSING: POSSIBLE
→GENERATE OBJPOS1,
EXECUTE RENDERING
POSITION $\beta$ AT TIME OF TRANSMISSION, AT TIME T$\beta$,
REFERENCE VIEWPOINTS TO BE REQUESTED {A, B, C}

F11

F12

B          C

F31

POSITION $\gamma$ AT TIME OF RECEPTION, AT TIME T$\gamma$,
REFERENCE VIEWPOINTS TO BE RECEIVED {A, B, C}
INTERPOLATION PROCESSING: IMPOSSIBLE
→DISCARD RECEIVED DATA
EXECUTE RENDERING USING OBJPOS1

D

## FIG. 14

EP 4 336 862 A1

SERVER **11**

- **101** CONFIGURATION INFORMATION RECORDING UNIT
- **21** CONFIGURATION INFORMATION TRANSMISSION UNIT
- **102** RECORDING UNIT
- **22** CODED DATA TRANSMISSION UNIT

CLIENT **12**

- **111** COMMUNICATION UNIT
- **42** VIEWPOINT SELECTION UNIT
- **41** LISTENER POSITION INFORMATION ACQUISITION UNIT
- **45** DECODING UNIT
- **112** POSITION CALCULATION UNIT
- **46** COORDINATE TRANSFORMATION UNIT
- **47** COORDINATE AXIS TRANSFORMATION PROCESSING UNIT
- **48** OBJECT POSITION CALCULATION UNIT
- **49** POLAR COORDINATE TRANSFORMATION UNIT
- **113** RENDERING PROCESSING UNIT

## FIG. 15

EP 4 336 862 A1

# FIG. 16

```
START OF VIEWPOINT SELECTION INFORMATION
TRANSMISSION PROCESSING BY CLIENT
```

ACQUIRE LISTENER POSITION INFORMATION  S51

SELECT REFERENCE VIEWPOINTS  S52

GENERATE VIEWPOINT SELECTION INFORMATION  S53

TRANSMIT VIEWPOINT SELECTION INFORMATION  S54

S55
TO END?
NO
YES

END

# FIG. 17

START OF PROVISION PROCESSING
BY SERVER

RECEIVE VIEWPOINT SELECTION INFORMATION | S81

GENERATE BIT STREAM | S82

TRANSMIT BIT STREAM | S83

END

## *FIG. 18*

```
        ┌─────────────────────────────────────────┐
        │   START OF REPRODUCTION AUDIO DATA       │
        │   GENERATION PROCESSING BY CLIENT        │
        └─────────────────────────────────────────┘
                         │
                         ▼
        ┌─────────────────────────────────────┐
        │        RECEIVE BIT STREAM            │ S111
        └─────────────────────────────────────┘
                         │
                         ▼
        ┌─────────────────────────────────────┐
        │        PERFORM DECODING              │ S112
        └─────────────────────────────────────┘
                         │
                         ▼
                    S113
              ◇ IS LISTENER          ◇  ─── NO ───┐
                IN TRIANGLE MESH?                   │
                         │                          │
                        YES                         │
                         ▼                          │
        ┌─────────────────────────────────────┐    │
        │ PERFORM COORDINATE TRANSFORMATION   │S114│
        └─────────────────────────────────────┘    │
                         │                          │
                         ▼                          │
        ┌─────────────────────────────────────┐    │
        │     PERFORM COORDINATE AXIS         │S115 │
        │     TRANSFORMATION PROCESSING       │    │
        └─────────────────────────────────────┘    │
                         │                          │
                         ▼                          │
        ┌─────────────────────────────────────┐    │
        │   PERFORM INTERPOLATION PROCESSING  │S116 │
        └─────────────────────────────────────┘    │
                         │                          │
                         ▼                          │
        ┌─────────────────────────────────────┐    │
        │    GENERATE POLAR COORDINATE        │S117 │
        │    POSITION INFORMATION             │    │
        └─────────────────────────────────────┘    │
                         │              ┌───────────┘ S118
                         │              ▼
                         │   ┌─────────────────────────────┐
                         │   │ OUTPUT POLAR COORDINATE      │
                         │   │ POSITION INFORMATION         │
                         │   │ OBTAINED LAST                │
                         │   └─────────────────────────────┘
                         ▼◄─────────────┘
        ┌─────────────────────────────────────┐
        │   PERFORM RENDERING PROCESSING      │S119
        └─────────────────────────────────────┘
                         │
                         ▼      S120
              ◇        TO END?        ◇ ─── NO ───┐ (back to RECEIVE BIT STREAM)
                         │
                        YES
                         ▼
                    ┌─────────┐
                    │   END   │
                    └─────────┘
```

## FIG. 19

A

B          C

D

F51

POSITION α AT TIME OF TRANSMISSION, AT TIME Tα,
REFERENCE VIEWPOINTS TO BE REQUESTED
{A, B, C, D}

F52

POSITION β AT TIME OF RECEPTION, AT TIME Tβ,
REFERENCE VIEWPOINTS TO BE RECEIVED {A, B, C, D}
INTERPOLATION PROCESSING: POSSIBLE
→EXECUTE INTERPOLATION PROCESSING USING
B, C, AND D, AND RENDERING

# FIG. 20

START OF VIEWPOINT SELECTION INFORMATION
TRANSMISSION PROCESSING BY CLIENT

ACQUIRE LISTENER POSITION INFORMATION | S151

SELECT REFERENCE VIEWPOINTS | S152

S153
IS ADDITIONAL
REFERENCE VIEWPOINT
TO BE SELECTED?      NO

YES

SELECT ADDITIONAL REFERENCE VIEWPOINT | S154

GENERATE VIEWPOINT SELECTION INFORMATION | S155

TRANSMIT VIEWPOINT SELECTION INFORMATION | S156

S157
TO END?
NO

YES

END

# FIG. 21

START OF REPRODUCTION AUDIO DATA
GENERATION PROCESSING BY CLIENT

RECEIVE BIT STREAM — S181

PERFORM DECODING — S182

S183
IS LISTENER IN TRIANGLE MESH? — NO

YES

S184
IS THERE INFORMATION OF TRIANGLE MESH INCLUDING LISTENER? — NO

YES

S189
OUTPUT POLAR COORDINATE POSITION INFORMATION OBTAINED LAST

PERFORM COORDINATE TRANSFORMATION — S185

PERFORM COORDINATE AXIS TRANSFORMATION PROCESSING — S186

PERFORM INTERPOLATION PROCESSING — S187

GENERATE POLAR COORDINATE POSITION INFORMATION — S188

PERFORM RENDERING PROCESSING — S190

S191
TO END? — NO

YES

END

# FIG. 22

A

POSITION $\alpha$ AT TIME OF TRANSMISSION, AT TIME T$\alpha$,
REFERENCE VIEWPOINTS TO BE REQUESTED
{A_$\beta$, B_$\beta$, C_$\beta$, D_$\beta$}

F61

B        C

F62

POSITION $\beta$ AT TIME OF RECEPTION, AT TIME T$\beta$,
REFERENCE VIEWPOINTS TO BE RECEIVED
{A_$\beta$, B_$\beta$, C_$\beta$, D_$\beta$}
INTERPOLATION PROCESSING: POSSIBLE
→EXECUTE INTERPOLATION PROCESSING USING
B_$\beta$, C_$\beta$, D_$\beta$, AND RENDERING

D

# FIG. 23

START OF VIEWPOINT SELECTION INFORMATION
TRANSMISSION PROCESSING BY CLIENT

ACQUIRE LISTENER POSITION INFORMATION — S221

ESTIMATE DELAY TIME — S222

SELECT REFERENCE VIEWPOINTS — S223

S224
IS ADDITIONAL REFERENCE VIEWPOINT TO BE SELECTED? — NO

YES

SELECT ADDITIONAL REFERENCE VIEWPOINT — S225

GENERATE VIEWPOINT SELECTION INFORMATION INCLUDING REQUEST TIME INFORMATION — S226

TRANSMIT VIEWPOINT SELECTION INFORMATION — S227

S228
TO END?
NO

YES

END

# FIG. 24

EP 4 336 862 A1

## INTERNATIONAL SEARCH REPORT

International application No.

**PCT/JP2022/003737**

### A. CLASSIFICATION OF SUBJECT MATTER

*H04S 7/00*(2006.01)i
FI: H04S7/00 320

According to International Patent Classification (IPC) or to both national classification and IPC

### B. FIELDS SEARCHED

Minimum documentation searched (classification system followed by classification symbols)

H04S7/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2019/049409 A1 (SHARP KK) 14 March 2019 (2019-03-14)<br>entire text, all drawings | 1-18 |

☐ Further documents are listed in the continuation of Box C.　　☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "E" | earlier application or patent but published on or after the international filing date | "X" document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **20 April 2022** | **10 May 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2022/003737**

| Patent document cited in search report | Publication date (day/month/year) | Patent family member(s) | Publication date (day/month/year) |
|---|---|---|---|
| WO 2019/049409 A1 | 14 March 2019 | US 2020/0280815 A1<br>entire text, all drawings | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019198540 A